# EUROPEAN PATENT APPLICATION

(11) **EP 4 797 923 A1**
(43) Date of publication of application: **26.08.2026**
(21) Application number: 24879893.6
(22) Date of filing: 19.07.2024
(51) Int. Cl.: H10K 59/38, H10K 59/35, H10K 59/80, H10K 59/122, H10K 59/12, H10K 71/50, H10K 77/10, H10K 71/10

(54) **DISPLAY DEVICE AND METHOD FOR MANUFACTURING DISPLAY DEVICE**

(30) Priority: 19.10.2023 KR 20230140731
(71) Applicant: Samsung Display Co., Ltd., Yongin-si, Gyeonggi-do 17113 (KR)
(72) Inventor: JOO, Sun Kyu, Yongin-si, Gyeonggi-do 17113 (KR); SHIN, Cheol, Yongin-si, Gyeonggi-do 17113 (KR); OH, Keun Chan, Yongin-si, Gyeonggi-do 17113 (KR); YOON, Ji Hwan, Yongin-si, Gyeonggi-do 17113 (KR); LEE, Seon Uk, Yongin-si, Gyeonggi-do 17113 (KR); LEE, Se Ho, Yongin-si, Gyeonggi-do 17113 (KR); JI, Woo Man, Yongin-si, Gyeonggi-do 17113 (KR); JIN, You Young, Yongin-si, Gyeonggi-do 17113 (KR); HWANG, Jae Hoon, Yongin-si, Gyeonggi-do 17113 (KR); HWANG, Tae Hyung, Yongin-si, Gyeonggi-do 17113 (KR)
(74) Representative: Marks & Clerk LLP
(86) International application number: PCT/KR2024/010431
(87) International publication number: WO 2025/084553

(57) **Abstract**

Provided is a display device, including sub-pixels formed on a base layer, and including a color conversion layer in a first sub-pixel area and including a quantum dot, a first scattering layer in a second sub-pixel area and including a first scatterer, and a second scattering layer in the third sub-pixel area and including a second scatterer, a first color filter in the first sub-pixel area, a second color filter in the second sub-pixel area, and a third color filter in the third sub-pixel area, wherein emitted light from a light emitting element includes light of the second color and light of the third color, and wherein colors of light passing through the first scattering layer and the second scattering layer are substantially unchanged by the first scattering layer and the second scattering layer.

## Description

### Technical Field

Aspects of some embodiments of the present disclosure relate to a display device and a method of fabricating the display device.

### Background Art

As interest in the display of information increases, research and development on display devices continues.

The above information disclosed in this Background section is for enhancement of understanding of the background of the present disclosure, and therefore, it may contain information that does not constitute prior art.

### Detailed Description of Invention

### Technical Problem

An aspect of the present disclosure is directed to a display device with improved light output efficiency, and a method of fabricating the display device.

An aspect of the present disclosure is directed to a display device capable of implementing sufficient luminance, and a method of fabricating the display device.

An aspect of the present disclosure is directed to a display device with improved process efficiency, and a method of fabricating the display device.

An aspect of the present disclosure is directed to a display device capable of reducing the production cost, and a method of fabricating the display device.

An aspect of the present disclosure is directed to a display device with excellent optical characteristics, and a method of fabricating the display device.

### Technical Solution

According to some embodiments of the present disclosure, there is provided a display device, including sub-pixels formed on a base layer, and including a first sub-pixel forming a first sub-pixel area and configured to provide light of a first color, a second sub-pixel forming a second sub-pixel area and configured to provide light of a second color, and a third sub-pixel forming a third sub-pixel area and configured to provide light of a third color, the sub-pixels including a display layer including a light emitting element on the base layer, a light controlling layer on the display layer, and including a color conversion layer in the first sub-pixel area and including a quantum dot, a first scattering layer in the second sub-pixel area and including a first scatterer, and a second scattering layer in the third sub-pixel area and including a second scatterer, and a color filter layer on the light controlling layer, and including a first color filter in the first sub-pixel area, a second color filter in the second sub-pixel area, and a third color filter in the third sub-pixel area, wherein emitted light from the light emitting element includes light of the second color and light of the third color, and at least a portion of the emitted light is emitted through the light controlling layer and the color filter layer, and wherein colors of light passing through the first scattering layer and the second scattering layer are substantially unchanged by the first scattering layer and the second scattering layer.

The display device may further include a capping layer, at least a portion of the capping layer may be configured to passivate the color conversion layer, wherein a first portion of the capping layer is on the color conversion layer in the first sub-pixel area, and a second portion of the capping layer is under the first scattering layer and the second scattering layer respectively in the second sub-pixel area and the third sub-pixel area.

The display device may further include an upper layer on the color filter layer, and may include an upper substrate, wherein the color filter layer and the light controlling layer are sequentially layered below the upper substrate, and wherein a filler layer is between the display layer and the color conversion layer, the first scattering layer, and the second scattering layer.

The display device may further include an upper layer on the color filter layer, and may include an upper substrate, wherein the light controlling layer is on the display layer, and wherein a filler layer is between the color filter layer and the color conversion layer, the first scattering layer, and the second scattering layer.

The display device may further include an upper layer on the color filter layer, and may include an upper film layer, wherein the light controlling layer and the color filter layer are successively layered on the display layer.

The color conversion layer may have a first thickness, wherein the first scattering layer has a second thickness, wherein the second scattering layer has a third thickness, wherein the first thickness is greater than each of the second thickness or the third thickness, and wherein the second thickness is substantially equal to the third thickness.

The first scatterer and the second scatterer may be included in a range from about 1.5 wt% to about 8.5 wt% with respect to the first scattering layer and the second scattering layer, respectively.

A size of the first scatterer may be greater than a size of the second scatterer.

The first scatterer may be included at a first weight ratio with respect to the first scattering layer, wherein the second scatterer is included at a second weight ratio with respect to the second scattering layer, and wherein the first weight ratio is greater than the second weight ratio.

The first scattering layer may include one or more scatterers having a same composition ratio as the first scatterer and a different size than the first scatterer, and the second scatter layer may include one or more scatterers having a same composition ratio as the second scatterer and a different size than the second scatterer.

The color filter layer may further include an optical layer having a refractive index less than a refractive index of the color conversion layer, the optical layer may be disposed between the light controlling layer and the first color filter, the second color filter, and the third color filter, and among the first sub-pixel area, the second sub-pixel area, and the third sub-pixel area, only the first sub-pixel area may include the optical layer.

The display device may further include a filler scattering layer in the second sub-pixel area and the third sub-pixel area, the filler scattering layer overlapping with the first scattering layer and the second scattering layer in a thickness direction, and including a filler material and a scattering material.

The display device may further include a bank, wherein at least a portion of the bank encloses the first sub-pixel area, and extends in a thickness direction.

The bank may not be between the second sub-pixel area and the third sub-pixel area, and the display device may further include a black matrix layer, at least a portion of the black matrix layer being between the second sub-pixel area and the third sub-pixel area, the black matrix layer penetrating between the first scattering layer and the second scattering layer.

The bank may be formed around all sides of the first sub-pixel area in a plan view, and may not be formed around at least a portion of each of the second sub-pixel area and the third sub-pixel area.

At least one side of the second sub-pixel area may include an open edge on which the bank is not formed, and wherein the open edge is formed to be oriented in a direction away from the third sub-pixel area.

The bank may be formed around all sides of both the first sub-pixel area and the second sub-pixel area in a plan view, and may not be formed around at least a portion of the third sub-pixel area.

The display device may further include a capping layer, at least a portion of the capping layer being configured to passivate the color conversion layer and the first scattering layer, wherein a portion of the capping layer is in the third sub-pixel area between the second scattering layer and the third color filter.

A thickness of the first scattering layer may be greater than a thickness of the second scattering layer.

The bank may further include an isolated bank component, wherein the isolated bank component is between the second sub-pixel area and the third sub-pixel area.

The display device may further include a spacer on the bank and above the color conversion layer, the first scattering layer, and the second scattering layer.

The spacer may be between the first sub-pixel area and the second sub-pixel area, between the second sub-pixel area and the third sub-pixel area, and between the first sub-pixel area and the third sub-pixel area.

The first sub-pixel, the second sub-pixel, and the third sub-pixel may be adjacent to each other in a first direction, and may form a first pixel, wherein the first pixel is adjacent to a second pixel in a second direction different from the first direction, and wherein the spacer is between the first sub-pixel area of the first pixel and the first sub-pixel area of the second pixel, between the second sub-pixel area of the first pixel and the second sub-pixel area of the second pixel, and between the third sub-pixel area of the first pixel and the third sub-pixel area of the second pixel.

The first sub-pixel area and the third sub-pixel area may be adjacent to each other in a first direction, and the second sub-pixel area may be adjacent to the first sub-pixel area and the third sub-pixel area in a second direction different from the first direction, wherein the spacer overlaps with the second sub-pixel area in the first direction.

The display device may further include a capping layer, at least a portion of the capping layer being configured to passivate the color conversion layer, the bank, the first scattering layer, the second scattering layer, and the spacer.

The display device may further include a capping layer, wherein at least a portion of the capping layer is configured to passivate the color conversion layer, the bank, the first scattering layer, and the second scattering layer, and wherein the spacer is disposed on the capping layer.

The bank may include a first bank part spaced apart from a second bank part by a first distance, the second sub-pixel area being between the first bank part and the second bank part, and a third bank part spaced apart from the second bank part by a second distance, the third sub-pixel area being between the third bank part and the second bank part, and wherein a thickness of the first scattering layer is greater than a thickness of the second scattering layer.

The light emitting element may include one or more of an organic light emitting diode including an organic material, or an inorganic light emitting diode including an inorganic material.

According to other embodiments of the present disclosure, there is provided a method of fabricating a display device, including fabricating a first panel, fabricating a second panel, and coupling the first panel and the second panel to each other, wherein fabricating the first panel includes providing a light emitting element on a lower substrate, wherein fabricating the second panel includes providing a color filter layer on an upper substrate, and providing a light controlling layer on the color filter layer, wherein the providing the light controlling layer includes patterning a bank on the color filter layer, placing a color conversion layer including a quantum dot in a first sub-pixel area, placing a first scattering layer including a first scatterer in a second sub-pixel area, and placing a second scattering layer including a second scatterer in a third sub-pixel area, and wherein the first scattering layer and the second scattering layer are configured to allow incident light to pass through the first scattering layer and the second scattering layer without changing a color of the incident light.

The providing the light controlling layer may further include forming a capping layer on the color conversion layer, the capping layer being configured to passivate the color conversion layer, wherein the providing the color conversion layer includes patterning the color conversion layer through an inkjet process, and wherein the providing the first scattering layer and providing the second scattering layer are performed after forming the capping layer, and are performed based on a photolithography process.

The color conversion layer, the first scattering layer, and the second scattering layer may be patterned based on a photolithography process, and the providing the light controlling layer may further include forming a capping layer on the color conversion layer, the capping layer being configured to passivate the color conversion layer.

The color conversion layer, the first scattering layer, and the second scattering layer may be formed based on an inkjet process.

The coupling the first panel and the second panel may further include providing a filler layer between the first panel and the second panel.

According to other embodiments of the present disclosure, there is provided a method of fabricating a display device, including fabricating a first panel, fabricating a second panel, and coupling the first panel and the second panel to each other, wherein the fabricating the first panel includes providing a display layer including a light emitting element on a lower substrate, and providing a light controlling layer on the display layer, wherein the fabricating the second panel includes providing a color filter layer on an upper substrate, wherein the providing the light controlling layer includes patterning a bank on the display layer, providing a color conversion layer including a quantum dot in a first sub-pixel area, providing a first scattering layer including a first scatterer in a second sub-pixel area, and providing a second scattering layer including a second scatterer in a third sub-pixel area, and wherein the first scattering layer and the second scattering layer are configured to allow incident light to pass through the first scattering layer and the second scattering layer without changing a color of the incident light.

The providing the light controlling layer may further include forming a capping layer on the color conversion layer, the capping layer being configured to passivate the color conversion layer, wherein providing the color conversion layer includes patterning the color conversion layer through an inkjet process, and wherein providing the first scattering layer and providing the second scattering layer are performed after forming the capping layer, and are performed based on a photolithography process.

The color conversion layer, the first scattering layer, and the second scattering layer may be patterned based on a photolithography process, and providing the light controlling layer may further include forming a capping layer on the color conversion layer, the capping layer being configured to passivate the color conversion layer, the first scattering layer, and the second scattering layer.

The color conversion layer, the first scattering layer, and the second scattering layer may be formed based on an inkjet process.

### Advantageous Effects

Aspects of some embodiments of the present disclosure may provide a display device with improved light output efficiency, and a method of fabricating the display device.

Aspects of some embodiments of the present disclosure may provide a display device capable of implementing sufficient luminance, and a method of fabricating the display device.

Aspects of some embodiments of the present disclosure may provide a display device with improved process efficiency, and a method of fabricating the display device.

Aspects of some embodiments of the present disclosure may provide a display device capable of reducing the production cost, and a method of fabricating the display device.

Aspects of some embodiments of the present disclosure may provide a display device with excellent optical characteristics, and a method of fabricating the display device.

### Description of Drawings

The above and other aspects and features of the present disclosure will be more clearly understood from the following detailed description of the illustrative, non-limiting embodiments with reference to the accompanying drawings.
FIG. 1 is a schematic plan view illustrating a display device, according to some embodiments of the present disclosure.
FIG. 2 is a schematic sectional view illustrating a display device, according to some embodiments of the present disclosure.
FIG. 3 is a schematic view illustrating a display layer, according to some embodiments of the present disclosure.
FIG. 4 is a schematic view for describing light paths for sub-pixels, according to some embodiments of the present disclosure.
FIGS. 5-7 are schematic sectional views each illustrating a display device, according to some embodiments of the present disclosure.
FIG. 8 is a schematic sectional view depicting a relationship in thickness among a first scattering layer, a second scattering layer, and a color conversion layer, according to some embodiments of the present disclosure.
FIGS. 9-11 are schematic sectional views depicting a relationship between scatterers included in each of the first scattering layer and the second scattering layer, according to some embodiments of the present disclosure.
FIGS. 12-15 are sectional views depicting characteristics of a light controlling layer, according to some embodiments of the present disclosure.
FIGS. 16-21 are plan views each depicting an arrangement relationship between a bank and sub-pixel areas, according to some embodiments of the present disclosure.
FIGS. 22-26 are plan views each depicting an arrangement relationship between a spacer and sub-pixel areas, according to some embodiments of the present disclosure.
FIG. 27 is a schematic plan view illustrating a display area of a display device, according to some embodiments of the present disclosure.
FIG. 28 is a schematic sectional view taken along line A-A' of FIG. 27, showing a schematic sectional view of a second panel, according to some embodiments of the present disclosure.
FIGS. 29-31 are schematic sectional views each illustrating a display device, according to some embodiments of the present disclosure.
FIGS. 32-34 are schematic sectional views each illustrating a display device, according to some embodiments of the present disclosure.
FIG. 35 is a schematic sectional view depicting a relationship between a first scattering layer and a second scattering layer, according to some embodiments of the present disclosure.
FIG. 36 is a flowchart illustrating a method of fabricating the display device, according to some embodiments of the present disclosure.
FIG. 37 is a flowchart illustrating sub-operations of the operation of fabricating the second panel, according to some embodiments of the present disclosure.
FIGS. 38-43 are schematic sectional views illustrating, by process operations, the method of fabricating the display device, according to some embodiments of the present disclosure.
FIG. 44 is a flowchart illustrating sub-operations of the operation of fabricating a second panel, according to some embodiments of the present disclosure.
FIGS. 45-48 are schematic sectional views illustrating, by process operations, the method of fabricating the display device, according to some embodiments of the present disclosure.
FIG. 49 is a flowchart illustrating a method of fabricating the display device, according to some embodiments of the present disclosure.

### Modes of the Invention

Hereinafter, some embodiments will be described in more detail with reference to the accompanying drawings. It should be noted that only the parts suitable for understanding operations in accordance with the present disclosure will be described below, and the description of the other parts will not be provided in order to not obscure the gist of the present disclosure. In some embodiments, the present disclosure is not limited to the embodiments described herein and may be embodied in other forms. Hereinafter, the embodiment will be described in more detail so that those of ordinary skill in the art can easily carry out the technical idea of the present disclosure.

As the present disclosure allows for various changes and numerous embodiments, particular embodiments will be illustrated in the drawings and described in more detail in the written description. However, this is not intended to limit the present disclosure to particular modes of practice, and it is to be appreciated that all changes, equivalents, and substitutes that do not depart from the spirit and technical scope of the present disclosure are encompassed in the present disclosure.

It will be understood that when a portion is referred to as being "connected to" another portion, it may be "directly connected to" the other portion or "indirectly connected to" the other portion with intervening portions therebetween. The terminology used herein is intended to describe specific embodiments and is not intended to limit the present disclosure. It will be understood that the terms "comprise," "include," or "have" as used herein specify the presence of stated elements, but do not preclude the presence or addition of one or more other elements. The expression "at least one of X, Y, and Z," "at least one of X, Y, or Z" and "at least one selected from the group consisting of X, Y, and Z" may be interpreted as one X, one Y, one Z, or any combination of two or more of X, Y, and Z (e.g., XYZ, XYY, YZ, ZZ, etc.). The terms "or" and "and/or" as used herein include any combination of one or more of the elements.

It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element. In the present disclosure, the singular forms are intended to include the plural forms as well, unless the context clearly indicates otherwise.

It will be further understood that the terms "comprise", "include", "have", etc. when used in the present disclosure, specify the presence of stated features, integers, steps, operations, elements, components, and/or combinations of them but do not preclude the presence or addition of one or more other features, integers, steps, operations, elements, components, and/or combinations thereof. Furthermore, in the case that a first part such as a layer, a film, a region, or a plate is disposed (e.g., located or provided) on a second part, the first part may be not only directly on the second part but a third part may intervene between them. In addition, when it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in the case that a first part such as a layer, a film, a region, or a plate is under a second part, the first part may be not only directly under the second part but a third part may intervene between them.

Spatially relative terms such as "below," "above," etc. may be used for descriptive purposes, thereby describing the relationship between one element or feature and another element(s) or feature(s) as illustrated in the drawings. Spatially relative terms are intended to include different directions in use, operation, and/or manufacture, in addition to the directions depicted in the drawings. For example, when the device illustrated in the figures is turned over, elements depicted as being located "below" other elements or features are located "above" the other elements or features. Accordingly, in some embodiments, the term "below" may include both up and down directions. In some embodiments, the device may be oriented in other directions (e.g., rotated by 90 degrees or in other orientations), and thus, the spatially relative terms as used herein should be interpreted accordingly.

Some embodiments are described with reference to the accompanying drawings in relation to functional blocks, units, and/or modules. Those of ordinary skill in the art will understand that these blocks, units, and/or modules are physically implemented by logic circuits, discrete components, microprocessors, hard-wired circuits, memory elements, wiring connections, and other electronic circuitry. This may be formed by using semiconductor-based manufacturing technologies or other manufacturing technologies. The blocks, units, and/or modules implemented by a microprocessor or other similar hardware may be programmed and controlled by using software to perform various functions discussed herein, and may optionally be driven by firmware and/or software. In some embodiments, the respective blocks, units, and/or modules may be implemented by dedicated hardware, or may be implemented as a combination of dedicated hardware that performs some functions and a processor (e.g., one or more programmed microprocessors and associated circuits) that performs other functions. In some embodiments, the blocks, units, and/or modules may be physically separated into two or more individual blocks, units, and/or modules that interact within the scope of the present disclosure. In some embodiments, the blocks, units, and/or modules may be physically combined into more complex blocks, units, and/or modules without departing from the scope of the present disclosure.

Various embodiments are described with reference to drawings that schematically illustrate non-limiting embodiments. Accordingly, it will be expected that the shapes may vary depending on, for example, tolerances and/or manufacturing techniques. Therefore, the embodiments disclosed herein should not be construed as limited to the illustrated specific shapes, but should be construed to include changes in shapes that occur, for example, as a result of manufacturing. As such, the shapes illustrated in the drawings may not depict the actual shapes of the areas of the device, and the present embodiments are not limited thereto.

When a certain embodiment may be implemented differently, a specific process order may be different from the described order. For example, two consecutively described processes may be performed at the same or substantially at the same time or may be performed in an order opposite to the described order.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Various embodiments of the present disclosure relate to a display device and a method of fabricating the display device. Hereinafter, a display device and a method of fabricating the display device in some embodiments will be described with reference to the attached drawings.

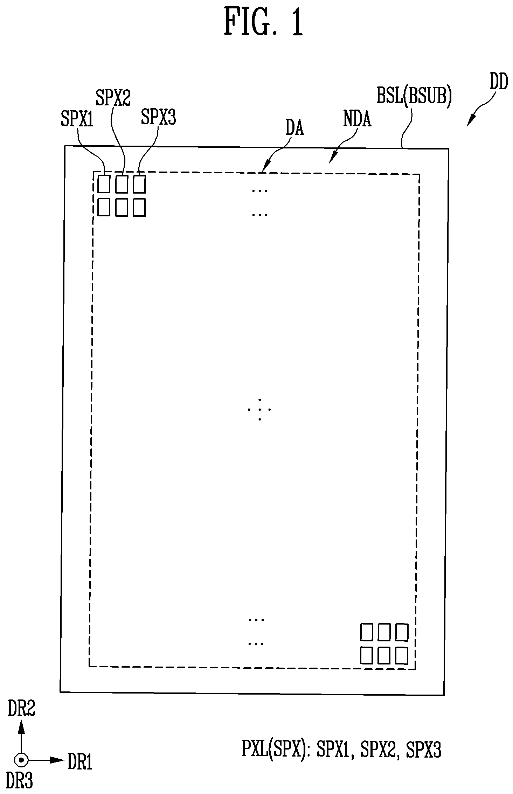

FIG. 1 is a schematic plan view illustrating the display device, according to some embodiments of the present disclosure.

Referring to FIG. 1, the display device DD may include a base layer BSL, and pixels PXL disposed (e.g., located or provided) on the base layer BSL. Although not illustrated in the drawing, the display device DD may further include a driving circuit component (e.g., a scan driver and a data driver), lines, and pads to drive the pixels PXL.

The display device DD (or the base layer BSL) may include a display area DA and a non-display area NDA. For example, the display area DA may be an area configured to display an image. The non-display area NDA may refer to an area other than the display area DA. The non-display area NDA may enclose at least a portion of the display area DA.

The base layer BSL may form a base surface of the display device DD. The base layer BSL may be a rigid or suitably flexible substrate or film. For example, the base layer BSL may include glass material. The base layer BSL may include silicon material. The base layer BSL may include polyimide. However, the present disclosure is not limited to the aforementioned examples.

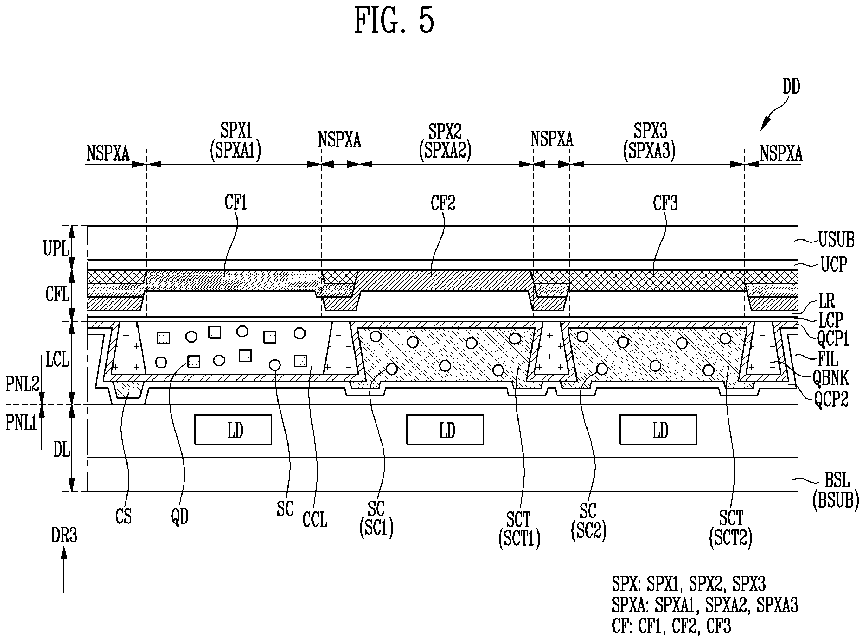

In some embodiments, the base layer BSL may be a lower substrate BSUB. For example, the base layer BSL may be a first substrate. The base layer BSL may include a base substrate provided to fabricate a first panel PNL1 (refer to FIG. 5).

The display area DA may refer to an area in which the pixels PXL are disposed. The non-display area NDA may refer to an area in which the pixels PXL are not disposed. The driving circuit component, the lines, and the pads which are connected to the pixels PXL of the display area DA may be disposed in the non-display area NDA.

In some embodiments, the pixels PXL (or sub-pixels SPX) may be arranged in a stripe or PENTILE^{™} arrangement structure or the like, but the present disclosure is not limited thereto. Various embodiments may be applied to the present disclosure.

In some embodiments, the pixel PXL (or the sub-pixels SPX) may include a first sub-pixel SPX1, a second sub-pixel SPX2, and a third sub-pixel SPX3. Each of the first sub-pixel SPX1, the second sub-pixel SPX2, and the third sub-pixel SPX3 may be a sub-pixel. At least one first sub-pixel SPX1, at least one second sub-pixel SPX2, and at least one third sub-pixel SPX3 may form one pixel unit which may emit various colors of light.

Each of the first sub-pixel SPX1, the second sub-pixel SPX2, and the third sub-pixel SPX3 may emit light in a single color.

For instance, the first sub-pixel SPX1 may be a red pixel configured to emit light in red (e.g., first color), the second sub-pixel SPX2 may be a green pixel configured to emit light in green (e.g., second color), and the third sub-pixel SPX3 may be a blue pixel configured to emit light in blue (e.g., third color). The red pixel may provide light in a wavelength band ranging from about 600 nm to about 750 nm. The green pixel may provide light in a wavelength band ranging from about 480 nm to about 560 nm. The blue pixel may provide light in a wavelength band ranging from about 370 nm to about 460 nm.

In some embodiments, the number of second sub-pixels SPX2 may be greater than the number of first sub-pixels SPX1, or the number of third sub-pixels SPX3. The colors, types, and/or numbers of first sub-pixels SPX1, second sub-pixels SPX2, and the third sub-pixels SPX3 which form each pixel unit are not limited to a specific example.

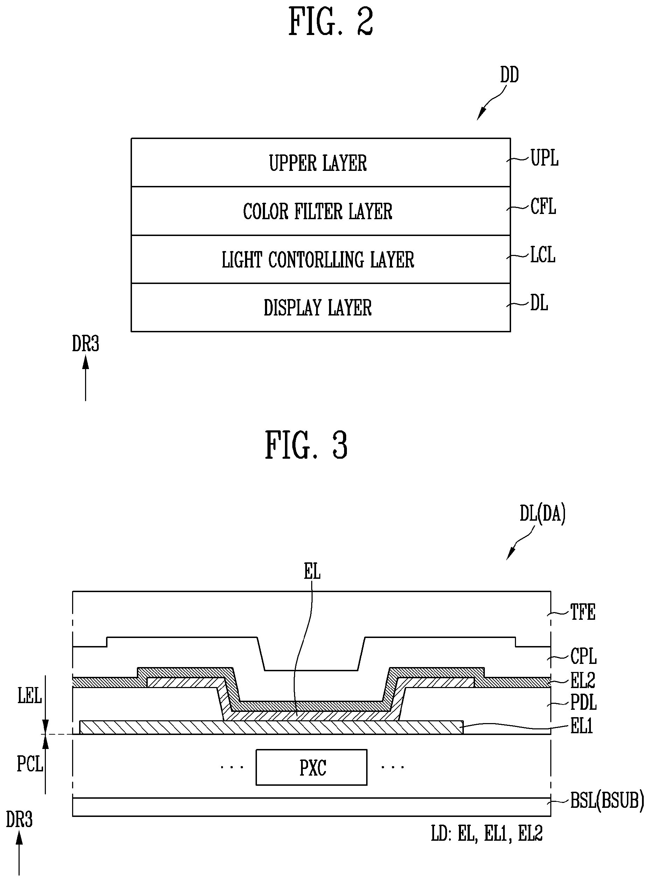

The overall structure of the display device DD including a cross-sectional (e.g., a sectional) structure thereof in some embodiments will be described with reference to FIGS. 2-4.

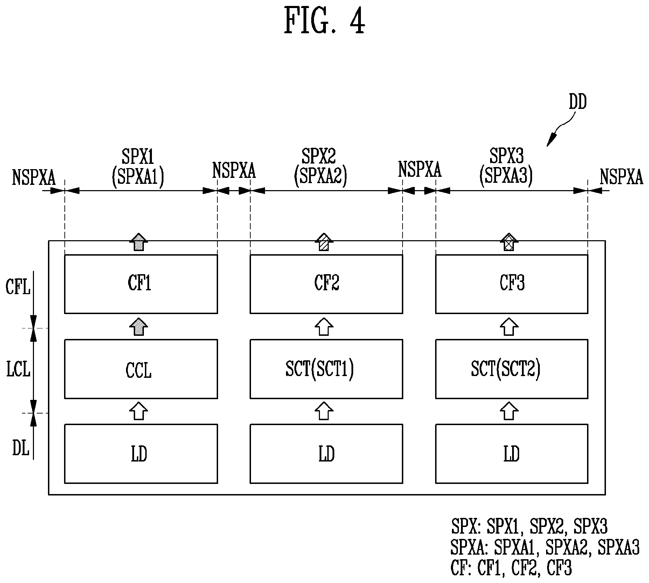

FIG. 2 is a schematic sectional view illustrating a display device, according to some embodiments of the present disclosure. FIG. 3 is a schematic view illustrating a display layer, according to some embodiments of the present disclosure. FIG. 4 is a schematic view for describing light paths for sub-pixels, according to some embodiments of the present disclosure.

Referring to FIGS. 2-4, the display device DD may include a display layer DL, a light controlling layer LCL, a color filter layer CFL, and an upper layer UPL.

The display layer DL may be configured to emit light. The display layer DL may form a base on which the light controlling layer LCL is disposed.

The display layer DL may include a pixel circuit layer PCL including the base layer BSL, and a light-emitting-element layer LEL capable of forming a pixel PXL including a light emitting element LD.

The base layer BSL may form a base on which the pixel circuit PXC is disposed. The pixel circuit PXC may be disposed on the base layer BSL, and may be configured to drive the light emitting element LD. The pixel circuit layer PCL may include conductive layers and insulating layers. The conductive layers may form the pixel circuit PXC. The pixel circuit PXC may include circuit elements configured to drive a sub-pixel SPX (or the light emitting element LD). The circuit elements may include a driving transistor, and may also include an additional transistor and capacitors.

The light-emitting-element layer LEL may be disposed on the pixel circuit layer PCL. In some embodiments, the light-emitting-element layer LEL may include the light emitting elements LD.

For example (refer to FIG. 3), the light emitting element LD may include an organic light emitting diode (OLED) including organic material. FIG. 3 schematically illustrates an embodiment in which the light emitting element LD is formed of an OLED, showing a schematic sectional structure of the display layer DL including the pixel circuit layer PCL and the light-emitting-element layer LEL as a sectional structure of the display device DD in the display area DA.

In some embodiments, the light-emitting-element layer LEL may further include a pixel defining layer PDL, a capping layer CPL, and an encapsulation layer TFE.

In some embodiments, the light emitting element LD may be disposed on the pixel circuit layer PCL. The light emitting element LD may include a first light emitting element (e.g., a first portion of the light emitting element LD) included in the first sub-pixel SPX1, a second light emitting element (e.g., a second portion of the light emitting element LD) included in the second sub-pixel SPX2, and a third light emitting element (e.g., a third portion of the light emitting element LD) included in the third sub-pixel SPX3.

In some embodiments, the light emitting element LD may include a first electrode EL1, an emission component EL, and a second electrode EL2. In some embodiments, the emission component EL may be disposed in an area defined by the pixel defining layer PDL. One surface of the emission component EL may be electrically connected to the first electrode EL1. The other surface of the emission component EL may be electrically connected to the second electrode EL2.

The first electrode EL1 may be an anode electrode for the emission component EL. The second electrode EL2 may be a cathode electrode for the emission component EL. In some embodiments, the first electrode EL1 and the second electrode EL2 may include conductive material. For example, the conductive material may include one or more selected from among gold (Au), silver (Ag), aluminium (Al), molybdenum (Mo), chromium (Cr), titanium (Ti), nickel (Ni), neodymium (Nd), copper (Cu), or platinum (Pt). In some examples, in some embodiments, the conductive material may include one or more selected from among silver nanowire (AgNW), indium tin oxide (ITO), indium zinc oxide (IZO), indium gallium zinc oxide (IGZO), antimony zinc oxide (AZO), indium tin zinc oxide (ITZO), zinc oxide (ZnO), tin oxide (SnO2), a carbon nanotube, or graphene. However, the present disclosure is not limited to the foregoing examples.

The emission component EL may emit light based on an electrical signal provided from the anode electrode (e.g., the first electrode EL1) and the cathode electrode (e.g., the second electrode EL2).

The emission component EL may include a multilayer structure. For example, the emission component EL may include a plurality of emission structures each including a hole transport component, an emission layer (or a light generating layer), and an electron transport component. Each of the layers that form the emission structure may include an organic material and, in some embodiments, may further include an inorganic material such as a metal-containing compound or quantum dot.

In some embodiments, the emission component EL may include a tandem structure. For example, the emission component EL may emit one color of light including a second color of light element and a third color of light element. For example, the emission structures may include a first emission structure and a second emission structure. The first emission structure may include a multilayer structure configured to emit light in the second color. The second emission structure may include a multilayer structure configured to emit light in the third color. Hence, the light emitted from the emission component EL may have a mixed color of the second color and the third color.

The hole transport component may include a multilayer structure having a plurality of layers respectively including different materials. For example, the hole transport component may include at least one of a hole injection layer and a hole transport layer and, in some embodiments, may further include an auxiliary emission layer, an electron blocking layer, and/or the like. For example, the hole transport component may have a multilayer structure, including hole injection layer/hole transport layer, hole injection layer/hole transport layer/auxiliary emission layer, hole injection layer/auxiliary emission layer, hole transport layer/auxiliary emission layer, electron blocking layer/hole injection layer/hole transport layer, sequentially-disposed hole transport layers containing different materials, or hole injection layer/hole transport layer/electron blocking layer. However, the present disclosure is not limited to a specific example.

The emission layer may include material capable of emitting light of one color. The emission layer may include a host and a dopant. The host of the emission layer may be emission material capable of capturing carriers (e.g., electrons and holes) for light generation, thus inducing efficient exciton generation. The dopant may include a phosphorescent dopant or a fluorescent dopant. In some embodiments, examples of the dopant are not specifically limited. In some embodiments, the dopant may include an organic material, and may include metal complex and/or the like.

The electron transport component may include a multilayer structure having a plurality of layers respectively including different materials. The electron transport component may include at least one of an electron injection layer and an electron transport layer and, in some embodiments, may further include an electron buffer layer, a hole blocking layer, and so on. For example, the electron transport component may have a multilayer structure, e.g., including electron transport layer/electron injection layer, hole blocking layer/electron transport layer/electron injection layer, electron control layer/electron transport layer/electron injection layer, or buffer layer/electron transport layer/electron injection layer. However, the present disclosure is not limited to a specific example.

The pixel defining layer PDL may be disposed on the pixel circuit layer PCL, and may define a position at which the emission component EL is to be disposed. The pixel defining layer PDL may include organic material. For example, the pixel defining layer PDL may be formed of one or more selected from among acryl resin, epoxy resin, phenol resin, polyamide resin, or polyimide resin. However, the present disclosure is not limited thereto. In some embodiments, the pixel defining layer PDL may include inorganic material. For example, the pixel defining layer PDL may include one or more of silicon oxide (SiOx) or silicon nitride (SiNx). In some embodiments, the pixel defining layer PDL may have a multilayer structure formed by stacking a layer including silicon oxide (SiOx) and/or a layer including silicon nitride (SiNx).

The capping layer CPL may be disposed on the second electrode EL2. The capping layer CPL may cap the second electrode EL2. The capping layer CPL may include an inorganic material.

The encapsulation layer TFE may be disposed on the light emitting element LD (e.g., the second electrode EL2). The encapsulation layer TFE may offset a step difference formed by the light emitting element LD and the pixel defining layer PDL. The encapsulation layer TFE may include a plurality of insulating layers configured to cover the light emitting element LD. In some embodiments, the encapsulation layer TFE may have a structure formed by alternately stacking inorganic layers and organic layers. In some embodiments, the encapsulation layer TFE may be formed of a thin film encapsulation layer.

In some embodiments, the light emitting element LD may be an inorganic light emitting diode including inorganic material. For example, the display device DD may include a structure in which light emitting elements LD including inorganic material are aligned between a plurality of electrodes spaced apart from each other. In some examples, the display device DD may include a structure in which the light emitting elements LD as micro light emitting diodes (micro LEDs) are transferred to the pixel circuit layer PCL in a transfer scheme. The transfer scheme may be one of a stamp-based transfer scheme, a laser-based transfer scheme, an electrostatic transfer scheme, a magnetic and electromagnetic transfer scheme, or an adhesive-based transfer scheme. However, the present disclosure is not limited to the aforementioned examples.

In the case where the light emitting element LD includes inorganic material, in some embodiments, the light emitting element LD may be configured to emit light including a light element in the second color and a light element in the third color. For example, a portion of the light emitting element LD may be configured to emit light including a light element in the second color, and another portion of the light emitting element LD may be configured to emit light including a light element in the third color.

The light controlling layer LCL may be disposed on the display layer DL (e.g., on the light-emitting-element layer LEL). For example, the light controlling layer LCL may be disposed on an upper side of the display layer DL with respect to a display direction (e.g., a third direction DR3), which is also referred to herein as a thickness direction.

In some embodiments, the light controlling layer LCL may be a layer capable of changing the color of applied light and scattering the applied light. For example, the light controlling layer LCL may include a color conversion layer CCL (refer to FIG. 5) and a scattering layer SCT (refer to FIG. 5). For example, a portion of the light controlling layer LCL, which corresponds to the color conversion layer CCL, may be provided to change the color of light applied thereto, and another portion of the light controlling layer LCL, which corresponds to the scattering layer SCT, may be provided to scatter light applied thereto.

The color filter layer CFL may be disposed on the light controlling layer LCL. For example, the color filter layer CFL may be disposed on an upper side of the light controlling layer LCL with respect to the display direction (e.g., the third direction DR3).

In some embodiments, the color filter layer CFL may include color filters CF (refer to FIG. 5), each of which may allow one color of light to selectively pass therethrough.

The upper layer UPL may be disposed on the color filter layer CFL. For example, the upper layer UPL may be disposed on an upper side of the color filter layer CFL with respect to the display direction (e.g., the third direction DR3).

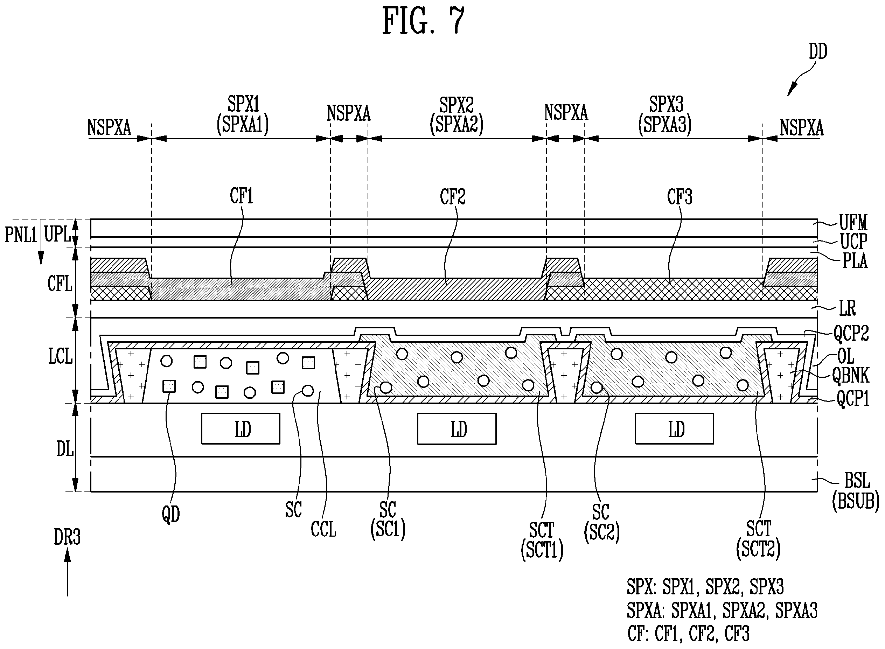

In some embodiments, the upper layer UPL may include an upper substrate USUB (refer to FIG. 5). The upper layer UPL may include an upper film layer UFM (refer to FIG. 7). In some embodiments, the upper substrate USUB may be a second substrate.

Structural characteristics of implementing a full-color display using the display device DD in accordance with some embodiments will be described with reference to FIG. 4. Description overlapping that of the embodiments described above will be simplified, or may not be repeated.

FIG. 4 is a schematic block diagram illustrating a light path provided for each sub-pixel in the display device, according to some embodiments of the present disclosure.

Referring to FIG. 4, the display device DD may include a sub-pixel area SPXA and a non-sub-pixel area NSPXA.

The sub-pixel area SPXA may be an area formed by a sub-pixel SPX to provide one color of light. The non-sub-pixel area NSPXA may be an area formed between adjacent sub-pixel areas SPXA, where one color of light is not provided.

The sub-pixel area SPXA may include a first sub-pixel area SPXA1 defined by the first sub-pixel SPX1 and formed to provide light in the first color, a second sub-pixel area SPXA2 defined by the second sub-pixel SPX2 and formed to provide light in the second color, and a third sub-pixel area SPXA3 defined by the third sub-pixel SPX3 and formed to provide light in the third color.

In some embodiments, the light controlling layer LCL and the color filter layer CFL may be sequentially disposed (e.g., may be provided one after the other in a sequence) on the display layer DL, thus defining the first to third sub-pixels SPX1 to SPX3.

In some embodiments, the light emitting elements LD may be respectively disposed in the first to third sub-pixel areas SPXA1 to SPXA3. For example, a first portion of the light emitting element LD may be provided in the first sub-pixel area SPXA1, a second portion of the light emitting element LD may be provided in the second sub-pixel area SPXA2, and a third portion of the light emitting element LD may be provided in the third sub-pixel area SPXA3. In some embodiments, each light emitting element LD may emit light in a certain color. For example, the light emitting elements LD that are respectively disposed in the first to third sub-pixel areas SPXA1 to SPXA3 may emit light in the same color.

In some embodiments, light emitted from the light emitting elements LD disposed in the sub-pixel areas SPXA may include a light element in the third color and a light element in the second color. For example, light emitted from the light emitting elements LD may be a mixture of light corresponding to a light spectrum of the third color and light corresponding to a light spectrum of the second color.

In some embodiments, the light controlling layer LCL may include the color conversion layer CCL disposed in the first sub-pixel area SPXA1, and may include the scattering layer SCT disposed in each of the second sub-pixel area SPXA2 and the third sub-pixel area SPXA3. For example, the scattering layer SCT may include a first scattering layer SCT1 disposed in the second sub-pixel area SPXA2, and a second scattering layer SCT2 disposed in the third sub-pixel area SPXA3.

In some embodiments, the color filter layer CFL may include a color filter CF. The color filter CF may include a first color filter CF1 disposed in the first sub-pixel area SPXA1, a second color filter CF2 disposed in the second sub-pixel area SPXA2, and a third color filter CF3 disposed in the third sub-pixel area SPXA3.

In the first sub-pixel area SPXA1, light emitted from the light emitting element LD may pass through the color conversion layer CCL and be thus provided as light in the first color. For example, the color conversion layer CCL may convert light in the third color (or the second color) into light in the first color. The light provided as light in the first color by passing through the color conversion layer CCL may pass through the first color filter CF1 and be eventually provided as light in the first color. Consequently, the first sub-pixel SPX1 may be configured to provide light in the first color.

In the second sub-pixel area SPXA2, light emitted from the light emitting element LD may pass through the first scattering layer SCT1 and be thus provided as light in the same color as the emitted light. The light provided in the same color as the emitted light by passing through the first scattering layer SCT1 may pass through the second color filter CF2 and be thus provided as light in the second color. For example, the second color filter CF2 allows light in the second color to selectively pass therethrough. Consequently, the second sub-pixel SPX2 may be configured to provide light in the second color.

In the third sub-pixel area SPXA3, light emitted from the light emitting element LD may pass through the second scattering layer SCT2 and be thus provided as light in the same color as the emitted light. The light provided in the same color as the emitted light by passing through the second scattering layer SCT2 may pass through the third color filter CF3 and be thus provided as light in the third color. For example, the third color filter CF3 allows light in the third color to selectively pass therethrough. Consequently, the third sub-pixel SPX3 may be configured to provide light in the third color.

In other words, in some embodiments, the color conversion layer CCL provided as a component in the light controlling layer LCL and configured to change the color of light in one color may be formed only in the first sub-pixel SPX1. In this case, technical effects may be provided, including sufficient light output efficiency and luminance, along with simplified process operations.

In some embodiments, the full-color display structure using the display device DD including red/green/blue respective sub-pixels SPX, even when the color conversion layer CCL with quantum dots QD is formed only in the first sub-pixel SPX1 for displaying red light without forming a color conversion structure including quantum dots in the second and third sub-pixels SPX2 and SPX3 for respectively displaying green and blue light, the display device DD may have desirable structural characteristics, ensuring sufficient light efficiency. For example, the display device DD may still provide sufficient light efficiency while being configured to have a simplified (e.g., a cost-effective) design by using a color conversion layer CCL for only one type of sub-pixel (e.g., red sub-pixels), among the three types of sub-pixels (e.g., red sub-pixels, green sub-pixels, and blue sub-pixels).

First, the reason why it is suitable for forming the first sub-pixel SPX1 using the color conversion layer CCL is as follows. Experimentally, in the case where the light emitting element LD emits light including a red light element, the red light element emitted from the light emitting element LD may have a relatively wide wavelength spectrum. In this case, even if the red light element emitted from the light emitting element LD passes through the first color filter CF1, it may be difficult to ensure sufficiently high light efficiency. For example, even if the red light element emitted from the light emitting element LD passes through the first color filter CF1, it may be difficult to ensure sufficiently high light purity. Therefore, to form the first sub-pixel SPX1 having sufficiently high light efficiency (e.g., sufficiently high light purity), it may be suitable for the light emitting element LD to be configured such that light emitted from the light emitting element LD includes a blue light element and the color conversion layer CCL is formed in the first sub-pixel SPX1 to convert blue light into red light. Consequently, in some embodiments, the first sub-pixel SPX1 may be implemented using the color conversion layer CCL and the first color filter CF1, whereby(e.g., such that) the first sub-pixel SPX1 may be capable of providing (e.g., ensuring) sufficient light efficiency and/or color purity (e.g., sufficiently high light efficiency and/or color purity).

Next, the reason why it is possible to form the second sub-pixel SPX2 without forming a color conversion structure including quantum dots is as follows. Experimentally, in the case where the light emitting element LD emits light including a green light element, the green light element emitted from the light emitting element LD may have a relatively narrow wavelength spectrum. In this case, even if the green light element emitted from the light emitting element LD passes through the second color filter CF2 without passing through a color conversion structure, sufficient light efficiency and/or color purity (e.g., sufficiently high light efficiency and/or sufficiently high color purity) can be provided (e.g., ensured) for the second sub-pixel area SPXA2 to emit green light. Based on the aforementioned principle, the light emitting element LD in some embodiments is configured to emit light including the green light element, and the second sub-pixel SPX2 includes the second color filter CF2 without including the color conversion structure, whereby the second sub-pixel SPX2 may be capable of emitting green light. Hence, the second sub-pixel SPX2 in some embodiments may have sufficient light efficiency and/or color purity (e.g., may have sufficiently high light efficiency and/or may have high color purity characteristics).

Similarly, light emitted from the light emitting element LD may include the blue light element. The blue light element emitted from the light emitting element LD may also have a relatively narrow wavelength spectrum. In this case, the third sub-pixel SPX3 may not include the color conversion structure with quantum dots. For example, even if the blue light element emitted from the light emitting element LD passes through the third color filter CF3 without passing through a color conversion structure, sufficient light efficiency and/or color purity (e.g., sufficiently high light efficiency and/or sufficiently high color purity) can be provided (e.g., ensured) for the third sub-pixel area SPXA3 to emit blue light.

In summary, based on red/green/blue light spectral characteristics, the color conversion structure can be applied only to some colors of sub-pixels SPX. Therefore, in some embodiments, there may be provided the display device DD configured such that each of the first to third sub-pixels SPX1 to SPX3 include the color conversion layer CCL, the first scattering layer SCT1, and the second scattering layer SCT2. In some embodiments, the display device DD may be configured such that only the first subpixels SPX1, among the first, second, and third sub-pixels SPX1 to SPX3, include the color conversion layer CCL. Consequently, the display device DD in some embodiments may have sufficiently high light efficiency. The method of fabricating the display device DD in some embodiments may simplify some process operations, thus leading to a reduction in the processing cost (e.g., a reduction in manufacturing costs).

The display device DD in accordance with some embodiments is discussed in further detail below with reference to FIGS. 5-27. Description overlapping that of the contents described above will be simplified, or may not be repeated.

In the display device DD in accordance with embodiments illustrated in FIGS. 5-27, the color conversion layer CCL may be fabricated through the inkjet process, and one or more of the first scattering layer SCT1 or the second scattering layer SCT2 may be fabricated through a photolithography process using a mask. For example, the color conversion layer CCL may be fabricated through the inkjet process, and the first scattering layer SCT1 and/or the second scattering layer SCT2 may be fabricated through the photolithography process.

FIGS. 5-7 are schematic sectional views each illustrating the display device, according to some embodiments of the present disclosure.

In some embodiments, layers of the display device DD may be fabricated on the same substrate, or may be fabricated on different substrates and then bonded together.

For example (refer to FIG. 5), a first panel PNL1 may be fabricated by forming the display layer DL on the lower substrate BSUB. A second panel PNL2 may be fabricated by forming the color filter layer CFL and the light controlling layer LCL on the upper substrate USUB. The first panel PNL1 and the second panel PNL2 may be coupled to each other by a filler layer FIL interposed between the first panel PNL1 and the second panel PNL2. As a result, the display device DD may be provided. In some embodiments, the first panel PNL1 and/or the second panel PNL2 may further include a dam structure to reduce (e.g., prevent) risks such as spreading of the filler layer FIL to the outside.

In some embodiments, the light controlling layer LCL may include a bank QBNK, a color conversion layer CCL, a first capping layer QCP1, a first scattering layer SCT1, a second scattering layer SCT2, a spacer CS, and a second capping layer QCP2, as components formed under the color filter layer CFL.

For example, the light controlling layer LCL may be formed on the upper substrate USUB and fabricated to include the second panel PNL2, and may be thus disposed under the color filter layer CFL.

In some embodiments, the bank QBNK may be disposed under the color filter layer CFL. For example, the bank QBNK may be disposed directly on an optical capping layer LCP. In some embodiments, in the case where the optical capping layer LCP is not formed, the bank QBNK may be disposed directly on an optical layer LR.

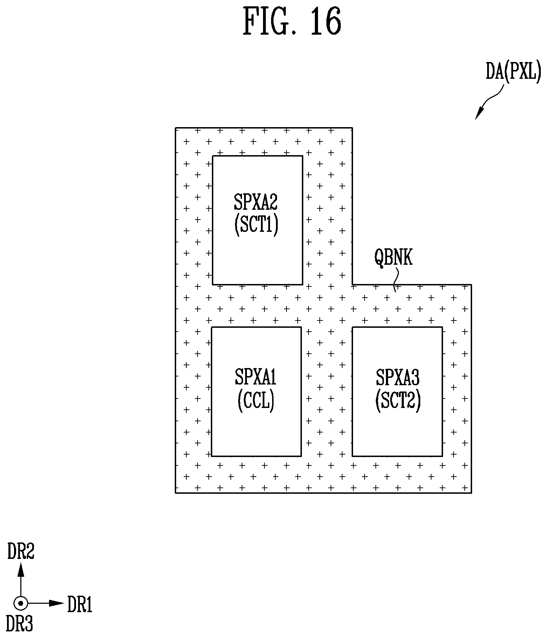

The bank QBNK may be disposed between adjacent sub-pixel areas SPXA, in a plan view. For example, the bank QBNK may overlap the non-sub-pixel area NSPXA, in the third direction DR3 (e.g., see the corresponding plan view of FIG. 16).

The bank QBNK may enclose at least a portion of one area. For example, the bank QBNK may enclose at least a portion of an area for forming the sub-pixel area SPXA, and protrude in a thickness direction (e.g., in the third direction DR3) of the lower substrate BSUB (e.g., the base layer BSL). Therefore, the bank BNK may form space where the color conversion layer CCL and the scattering layer SCT can be disposed (e.g., received).

The plane defined in this specification may extend in a first direction DR1 and a second direction DR2 (e.g., see FIG. 1), and may be defined based on a plane on which the base layer BSL is disposed. In some embodiments, the third direction DR3 may correspond to the thickness direction of the base layer BSL. The third direction DR3 may correspond to a light output direction of the display device DD.

In some embodiments, the bank QBNK may include a tapered side surface that is recessed on a side portion adjacent to a surface on which the bank QBNK is disposed. In this case, the surface area of a portion enclosed by the bank QBNK may expand outward based on the light emission direction. For example, an area surrounded by a lower portion of the bank QBNK may be smaller than an area surrounded by an upper portion of the bank QBNK.

The bank QBNK may include various materials. For example, the bank QBNK may include organic material. In some embodiments, the bank QBNK may be formed of one or more selected from among acryl resin, epoxy resin, phenol resin, polyamide resin, or polyimide resin. In some embodiments, the bank QBNK may further include scattering material {e.g., titanium oxide (TiOx)}. However, the present disclosure is not limited thereto.

The color conversion layer CCL may be disposed under the color filter layer CFL. For example, the color conversion layer CCL may be disposed directly on the optical capping layer LCP. In some embodiments, in the case where the optical capping layer LCP is not formed, the color conversion layer CCL may be disposed directly on the optical layer LR.

The color conversion layer CCL may be formed in the first sub-pixel area SPXA1. The color conversion layer CCL may overlap the first sub-pixel area SPXA1 in a plan view (e.g., the third direction DR3), but may neither overlap the second sub-pixel area SPXA2 nor the third sub-pixel area SPXA3.

The color conversion layer CCL may be a component provided to form the first sub-pixel SPX1. For example, the color conversion layer CCL may include first color conversion particles to convert light provided from the light emitting element LD (e.g., light including a light element in the second color and a light element in the third color) into light in the first color. For example, the color conversion layer CCL may include quantum dots QD provided to convert light in the third color to light in the first color. The quantum dots QD may absorb light in the third color, shift the wavelength thereof according to an energy transition, and thus emit light in the first color. The quantum dots QD may be dispersed in a matrix layer formed of organic material and/or the like.

The first capping layer QCP1 may be disposed over the sub-pixel areas SPXA and the non-sub-pixel areas NSPXA. The first capping layer QCP1 may be disposed on at least portions of the bank QBNK, the color conversion layer CCL, and the optical capping layer LCP.

The first capping layer QCP1 may be positioned in the first sub-pixel area SPXA1 over the color conversion layer CCL based on the base (e.g., the color conversion layer CFL, the optical layer LR, or the optical capping layer LCP) on which the light controlling layer LCL (e.g., the color conversion layer CCL) is disposed. The first capping layer QCP1 may be positioned in the second and third sub-pixel areas SPXA2 and SPXA3 on (e.g., under) the first and second scattering layers SCT1 and SCT2 based on the base (e.g., the color conversion layer CFL, the optical layer LR, or the optical capping layer LCP) on which the light controlling layer LCL (e.g., the first and second scattering layers SCT1 and SCT2) is disposed. For example, the first capping layer QCP1 may passivate the color conversion layer CCL. The first capping layer QCP1 may be disposed (e.g., directly disposed) on the optical capping layer LCP in the second sub-pixel area SPXA2 and the third sub-pixel area SPXA3. In some embodiments, in the case where the optical capping layer LCP is not formed, the first capping layer QCP1 may be disposed (e.g., directly disposed) on the optical layer LR in the second sub-pixel area SPXA2 and the third sub-pixel area SPXA3.

Herein, the first capping layer QCP1 may be referred to as a "capping layer."

The first capping layer QCP1 may be fabricated after the inkjet process of fabricating the color conversion layer CCL, and may be fabricated before the photolithography process of fabricating the first scattering layer SCT1 and the second scattering layer SCT2. Therefore, the first capping layer QCP1 may be positioned under the color conversion layer CCL, and may be positioned over the first scattering layer SCT1 and the second scattering layer SCT2.

The first capping layer QCP1 may be an inorganic layer, and be formed of one or more selected from among silicon nitride (SiNx), aluminium nitride (AlNx), titanium nitride (TiNx), silicon oxide (SiOx), aluminium oxide (AlxOy), titanium oxide (TiOx), silicon oxycarbide (SiOxCy), or silicon oxynitride (SiOxNy). However, the present disclosure is not limited to the aforementioned examples.

The first scattering layer SCT1 and the second scattering layer SCT2 may be positioned under the color filter layer CFL. For example, the first scattering layer SCT1 and the second scattering layer SCT2 may be disposed (e.g., directly disposed) on the first capping layer QCP1. For example, a process of forming the first scattering layer SCT1 and the second scattering layer SCT2 may be performed after the first capping layer QCP1 is fabricated (e.g., after the first capping layer QCP1 passivates the color conversion layer CCL). Consequently, the first scattering layer SCT1 and the second scattering layer SCT2 may be directly adjacent to the first capping layer QCP1.

The first scattering layer SCT1 may be formed in the second sub-pixel area SPXA2. The second scattering layer SCT2 may be formed in the third sub-pixel area SPXA3. The first scattering layer SCT1 may overlap the second sub-pixel area SPXA2 in a plan view (e.g., in the third direction DR3). The second scattering layer SCT2 may overlap the third sub-pixel area SPXA3 in a plan view (e.g., in the third direction DR3). The first scattering layer SCT1 and the second scattering layer SCT2 may not overlap the first sub-pixel area SPXA1.

The first scattering layer SCT1 and the second scattering layer SCT2 may be layers provided to enhance light output efficiency (e.g., luminance) and improve viewing angle characteristics. For example, each of the first scattering layer SCT1 and the second scattering layer SCT2 may include scatterers SC. The scatterers SC may be dispersed in a matrix formed of organic material (e.g., transparent organic material) or the like. In some embodiments, the scatterers SC may include first scatterers SC1 included in the first scattering layer SCT1, and second scatterers SC2 included in the second scattering layer SCT2.

In some embodiments, the concentration of the first scatterers SC1 in the first scattering layer SCT1 and the concentration of the second scatterers SC2 in the second scattering layer SCT2 may differ from each other. Consequently, a light characteristic relationship between the second and third sub-pixels SPX2 and SPX3 may be adjusted based on the concentrations of the first and second scatterers SC1 and SC2.

In some embodiments, the scatterers SC may include various light scattering particles. For example, the scatterers SC may include one or more selected from among titanium oxide (TiOx), silica (SiOx) (e.g., silica beads, hollow silica particles, or the like), zirconium oxide (ZrOx), aluminium oxide (AlxOy), indium oxide (InxOy), zinc oxide (ZnOx), tin oxide (SnOx), or antimony oxide (SbxOy). However, the present disclosure is not limited to the aforementioned example.

In some embodiments, the scatterers SC may be included in a range from about 0.1 wt% to about 8.5 wt% with respect to the scattering layer SCT. In some embodiments, the scatterers SC may be included in a range from about 1.5 wt% to about 8.5 wt% with respect to the scattering layer SCT. In some embodiments, the scatterers SC may be included in a range from about 4.0 wt% to about 7.5 wt% with respect to the scattering layer SCT. The aforementioned numerical range may be independently applied to each of the first scattering layer SCT1 and the second scattering layer SCT2. However, the present disclosure is not limited to the aforementioned examples.

Each of the first scattering layer SCT1 and the second scattering layer SCT2 may not include a quantum dot as a color conversion particle. For example, the first scattering layer SCT1 may not include a quantum dot for providing green light. For example, the second scattering layer SCT2 may not include a quantum dot for providing blue light. Therefore, the first scattering layer SCT1 and the second scattering layer SCT2 may transmit incident light without changing the color of the incident light.

In this specification, the words "without changing the color of light applied to the first scattering layer SCT1 and the second scattering layer SCT2" may imply that the color of light before and after passing through the first scattering layer SCT1 and the second scattering layer SCT2 is substantially the same. For example, the light before passing through the first scattering layer SCT1 may be light including a mixture of green light and blue light (or may have a wavelength band including a green light element and a blue light element). The light after passing through the first scattering layer SCT1 may be light including a mixture of green light and blue light (or may have a wavelength band including a green light element and a blue light element). The light before passing through the second scattering layer SCT2 may be light including a mixture of green light and blue light (or may have a wavelength band including a green light element and a blue light element). The light after passing through the second scattering layer SCT2 may be light including a mixture of green light and blue light (or may have a wavelength band including a green light element and a blue light element).

In some embodiments, the color conversion layer CCL may also include scatterers SC. In this case, in an area where the color conversion layer CCL is formed, light emitted from the light emitting element LD may be scattered, and viewing angle characteristics in the first sub-pixel SPX1 may be improved.

In some embodiments, the first scattering layer SCT1 and the second scattering layer SCT2 may be fabricated through the same photolithography process. In this case, at least some of the process operations for fabricating the second sub-pixel SPX2 and the third sub-pixel SPX3 may be simplified. However, the present disclosure is not limited to the aforementioned example. After a first photolithography process for fabricating the first scattering layer SCT1 is performed, a second photolithography process for fabricating the second scattering layer SCT2 may be performed. In some examples, after the second photolithography process for fabricating the second scattering layer SCT2 is performed, the first photolithography process for fabricating the first scattering layer SCT1 may be performed.

In some embodiments, as the first scattering layer SCT1 and the second scattering layer SCT2 are fabricated based on the photolithography process, the sub-pixels SPX may be fabricated to be more fine, thus enabling the production of a display device DD with high performance (e.g., high resolution or the like).

The spacer CS may be disposed in the non-sub-pixel area NSPXA. In some embodiments, the spacer CS may not overlap the sub-pixel area SPXA, in a plan view (e.g., in the third direction DR3).

The spacer CS may be disposed on the bank QBNK. For example, the spacer CS may be disposed between the bank QBNK and the display layer DL. The spacer CS may be disposed directly on the first capping layer QCP1.

The spacer CS may be disposed above the color conversion layer CCL, the first scattering layer SCT1, and the second scattering layer SCT2, based on the base on which the light controlling layer LCL is disposed. For example, the spacer CS may protrude in the thickness direction (e.g., the third direction DR3) of the lower substrate BSUB (e.g., the base layer BSL). The spacer CS may form a spacing distance between the display layer DL and the other components of the light controlling layer LCL during a process of coupling the first panel PNL1 and the second panel PNL2 to each other. To this end, the spacer CS may be most adjacent to the display layer DL, compared to the color conversion layer CCL, the first scattering layer SCT1, and the second scattering layer SCT2.

The spacer CS may be fabricated through the same photolithography process as at least any one of the first scattering layer SCT1 and the second scattering layer SCT2. Hence, the process operation of forming the spacer CS may be simplified, thus leading to a reduction in the processing cost. For example, the spacer CS may be formed through the same process as the first scattering layer SCT1. In some examples, the spacer CS may be formed through the same process as the second scattering layer SCT2. As a further alternative, the spacer CS may be formed through the same process as the first scattering layer SCT1 and the second scattering layer SCT2.

The spacer CS may be fabricated through the same process as at least any one of the first scattering layer SCT1 and the second scattering layer SCT2, and have the same material as at least any one, and may have scatterers SC.

The second capping layer QCP2 may be disposed over the sub-pixel areas SPXA and the non-sub-pixel areas NSPXA. The second capping layer QCP2 may be disposed on the first capping layer QCP1, the first scattering layer SCT1, the second scattering layer SCT2, and the spacer CS. The second capping layer QCP2 may passivate the first scattering layer SCT1 and the second scattering layer SCT2.

The second capping layer QCP2 may be fabricated after the photolithography process for fabricating the first scattering layer SCT1 and the second scattering layer SCT2.

The second capping layer QCP2 may be an inorganic layer, and be formed of one or more selected from among silicon nitride (SiNx), aluminium nitride (AlNx), titanium nitride (TiNx), silicon oxide (SiOx), aluminium oxide (AlxOy), titanium oxide (TiOx), silicon oxycarbide (SiOxCy), or silicon oxynitride (SiOxNy). However, the present disclosure is not limited to the aforementioned example.

As described above, the filler layer FIL may be interposed between the first panel PNL1 and the second panel PNL2. The filler layer FIL may include various transparent organic materials, and examples thereof are not specifically limited.

In some embodiments, the color filter layer CFL may include the color filters CF, the optical layer LR, and the optical capping layer LCP, as components formed under the upper layer UPL.

For example, the color filter layer CFL may be formed on the upper substrate USUB and fabricated to be included in the second panel PNL2, and may be thus disposed under the upper layer UPL.

In some embodiments, the color filters CF may include a first color filter CF1 provided to form the first sub-pixel SPX1, a second color filter CF2 provided to form the second sub-pixel SPX2, and a third color filter CF3 provided to form the third sub-pixel SPX3.

The color filters CF may be disposed under the upper substrate USUB. For example, the color filters CF may be disposed directly on the upper capping layer UCP.

The first color filter CF1 may be disposed in the first sub-pixel area SPXA1. The first color filter CF1 may include color filter material (e.g., pigment or dye) for allowing the first color of light (e.g., red light) to pass therethrough (e.g., to selectively pass therethrough).

The second color filter CF2 may be disposed in the second sub-pixel area SPXA2. The second color filter CF2 may include color filter material (e.g., pigment or dye) for allowing the second color of light (e.g., green light) to pass therethrough (e.g., to selectively pass therethrough).

The third color filter CF3 may be disposed in the third sub-pixel area SPXA3. The third color filter CF3 may include color filter material (e.g., pigment or dye) for allowing the third color of light (e.g., blue light) to pass therethrough (e.g., to selectively pass therethrough).

In some embodiments, the non-sub-pixel area SPXA where light in one color may not be visible may be formed between the sub-pixel areas SPXA. In some embodiments, the first color filter CF1, the second color filter CF2, and the third color filter CF3 may overlap each other in the non-sub-pixel area SPXA, in a plan view (e.g., in the third direction DR3).

The optical layer LR may be disposed on the color filters CF. The optical layer LR may be disposed over the sub-pixel areas SPXA and the non-sub-pixel areas NSPXA.

The optical layer LR may have a higher refractive index than layers that form the color filters CF. The optical layer LR may have a lower refractive index than the color conversion layer CCL, and may form an optical recycling structure.

The optical layer LR may include various materials to have a refractive index. For example, the optical layer LR may include various resins and hollow silica. In some examples, the optical layer LR may include zirconium oxide (ZrOx). However, the present disclosure is not limited to the aforementioned examples.

Herein, the optical layer LR may be referred to as a low refractive layer.

The optical capping layer LCP may be disposed on the optical layer LR. The optical capping layer LCP may be disposed over the sub-pixel areas SPXA and the non-sub-pixel areas NSPXA. The optical capping layer LCP may passivate the optical layer LR.

The optical capping layer LCP may include one or more of examples described with reference to the first capping layer QCP1. In some embodiments, the optical capping layer LCP may be omitted (e.g., may not be provided).

In some embodiments, the upper substrate USUB may be disposed on the color filter layer CFL as a base component for fabricating the second panel PNL2. In some embodiments, the upper capping layer UCP may be disposed on the upper substrate USUB.

The upper substrate USUB may be a fabrication substrate provided to fabricate the second panel PNL2, and may include one or more of the materials described above with reference to the lower substrate BSUB (e.g., the base layer BSL). For example, the upper substrate USUB may include an organic substrate.

The upper capping layer UCP may be disposed between the upper substrate USUB and the color filters CF, and may include one or more of examples (e.g., materials) described above with reference to the first capping layer QCP1.

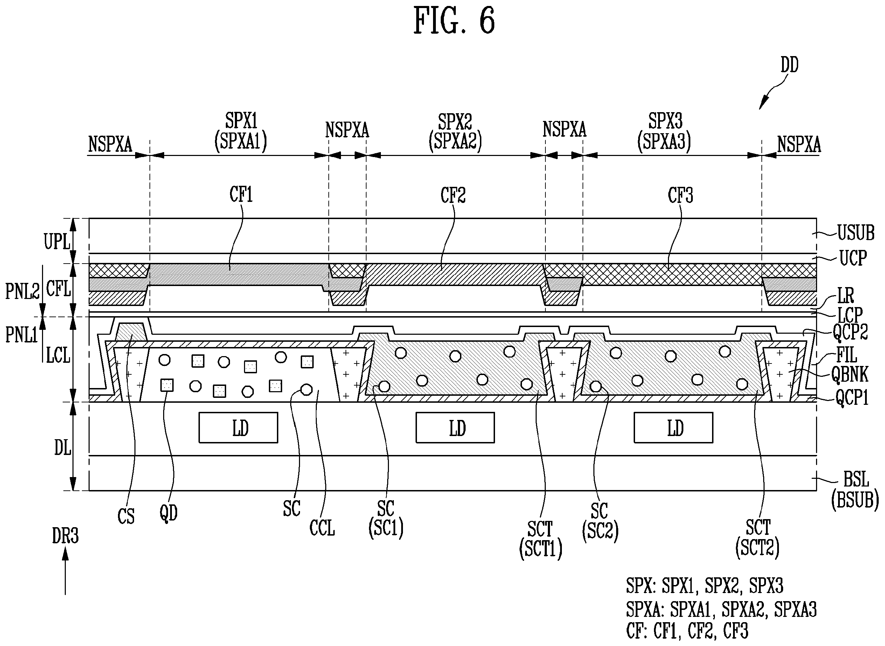

In some embodiments (refer to FIG. 6), the first panel PNL1 may be fabricated by forming the display layer DL and the light controlling layer LCL on the lower substrate BSUB. The second panel PNL2 may be fabricated by forming the color filter layer CFL on the upper substrate USUB. The first panel PNL1 and the second panel PNL2 may be coupled to each other by the filler layer FIL interposed between the first panel PNL1 and the second panel PNL2. As a result, the display device DD may be provided.

For example, the display device DD illustrated in FIG. 6 is different from the display device DD illustrated in FIG. 5 in that the components for forming the light controlling layer LCL (e.g., the bank QBNK, the color conversion layer CCL, the first capping layer QCP1, the first scattering layer SCT1, the second scattering layer SCT2, the spacer CS, and the second capping layer QCP2) are disposed on the lower substrate BSUB (e.g., even before the first panel PNL1 and the second panel PNL2 are coupled to each other).

Hence, the color conversion layer CCL, the first scattering layer SCT1, and the second scattering layer SCT2 may be disposed adjacent to the display layer DL and be included in the first panel PNL1. The filler layer FIL may be interposed between the color filter layer CFL and the layers that form the light controlling layer LCL.

In some embodiments (refer to FIG. 7), the first panel PNL1 may be fabricated by forming the display layer DL, the light controlling layer LCL, the color filter layer CFL, and the upper layer UPL on the lower substrate BSUB without separately forming the upper substrate USUB. The display device DD may be provided without performing a separate process of coupling the panels to each other.

In this case, the display device DD illustrated in FIG. 7 is different from the display device DD illustrated in FIG. 6 in that the color filter layer CFL and the upper layer UPL are also disposed on the lower substrate BSUB.

In this case, the optical layer LR and the color filter layer CF may be sequentially disposed on the light controlling layer LCL. Furthermore, in some embodiments, a planarization layer PLA including organic material may also be disposed on the color filter layer CF. In some embodiments, the upper substrate USUB may not be formed, and the upper film layer UFM may be disposed on the upper capping layer UCP. In some embodiments, the upper film layer UFM may include one selected from among a polyethyleneterephthalate (PET) film, a low reflection film, a polarizing film, or a transmittance controllable film. The present disclosure is not limited to the aforementioned examples.

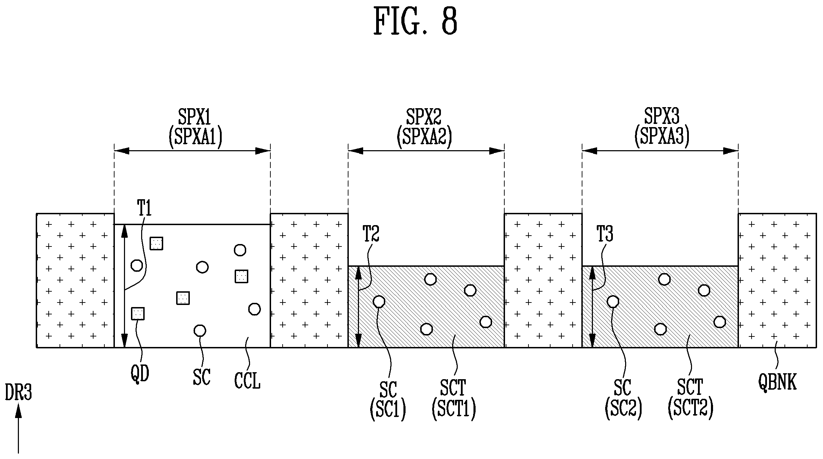

Various technical characteristics pertaining to the light controlling layer LCL are discussed below with reference to FIGS. 8-27.

FIG. 8 is a schematic sectional view for describing a relationship in thickness among the first scattering layer, the second scattering layer, and the color conversion layer in some embodiments.

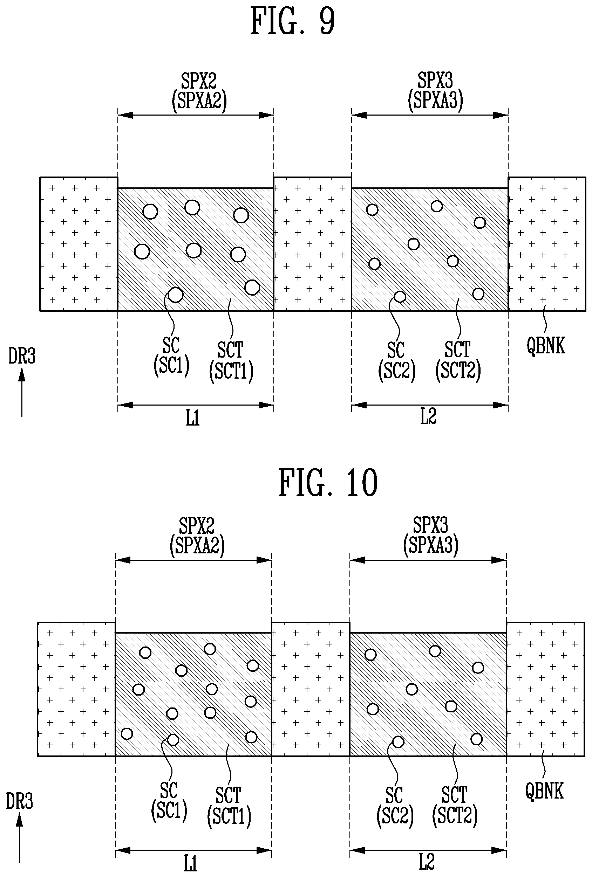

FIGS. 9-11 are schematic sectional views depicting a relationship between scatterers included in each of the first scattering layer and the second scattering layer, according to some embodiments of the present disclosure.

FIG. 8 illustrates the first sub-pixel area SPXA1, the second sub-pixel area SPXA2, the third sub-pixel area SPXA3, and areas adjacent thereto, according to some embodiments of the present disclosure. For example, FIG. 8 illustrates the color conversion layer CCL disposed in the first sub-pixel area SPXA1, and the first scattering layer SCT1 and the second scattering layer SCT2 that are disposed in the second sub-pixel area SPXA2 and the third sub-pixel area SPXA3, and illustrates the bank QBNK that encloses the color conversion layer CCL, the first scattering layer SCT1 and the second scattering layer SCT2. Referring to FIG. 8, the color conversion layer CCL may have a thickness greater than each of the first and second scattering layers SCT1 and SCT2. In this specification, the term "thickness" may be defined based on the thickness direction of the base layer BSL (e.g., the third direction DR3).

For example, the color conversion layer CCL may have a first thickness T1. The first scattering layer SCT1 may have a second thickness T2. The second scattering layer SCT2 may have a third thickness T3. The first thickness T1 may be greater than each of the second thickness T2 and the third thickness T3. In some embodiments, the second thickness T2 and the third thickness T3 may be substantially the same as each other.

In some embodiments, it may be desirable that the sub-pixels SPX have substantially uniform light output efficiency. For example, it may be suitable for the first sub-pixel SPX1, the second sub-pixel SPX2, and the third sub-pixel SPX3 to have light output efficiencies corresponding to (e.g., light output efficiencies that are substantially same as) each other.

The first sub-pixel SPX1 provided to emit light in the first color may be implemented by the color conversion layer CCL, and therefore have relatively low color implementation efficiency (e.g., current efficiency), compared to the second and third sub-pixels SPX1 and SPX2.

In some embodiments, the first thickness T1 of the color conversion layer CCL included in the first sub-pixel SPX1 may be defined to be greater than each of the second and third thicknesses T2 and T3 of the first and second scattering layers SCT1 and SCT2 included in the second and third sub-pixels SPX2. In this case, the color conversion layer CCL may be defined to be relatively thick, thus having a larger amount of scatterers SC compared to the first and second scattering layers SCT1 and SCT2, whereby a difference in color implementation efficiency between the first to third sub-pixels SPX1 to SPX3 can be compensated for.

Furthermore, the first and second scattering layers SCT1 and SCT2 each of which does not include a quantum dot may have thicknesses corresponding to each other (e.g., thicknesses that are substantially the same as each other), thus leading to enhanced process convenience.

FIGS. 9-11 illustrate the second sub-pixel area SPXA2, the third sub-pixel area SPXA3, and areas adjacent thereto, according to some embodiments of the present disclosure. For example, FIGS. 9-11 illustrate the first scattering layer SCT1 and the second scattering layer SCT2 that are disposed in the second sub-pixel area SPXA2 and the third sub-pixel area SPXA3, and illustrate the bank QBNK that encloses the first scattering layer SCT1 and the second scattering layer SCT2.

In some embodiments, the adjacent banks QBNK that enclose the first scattering layer SCT1 may be spaced apart from each other by a first distance L1. The adjacent banks QBNK that enclose the second scattering layer SCT2 may be spaced apart from each other by a second distance L2.

Referring to FIG. 9, in some embodiments, each of the first scatterers SC1 may be larger than each of the second scatterers SC2. In this case, in some embodiments, the first scattering layer SCT1 and the second scattering layer SCT2 may be fabricated through separate processes.

In this specification, the size of the scatterers SC may refer to a maximum diameter that can be defined for particles constituting the scatterers SC.

For example, in some embodiments, where the scatterer SC has an elliptical shape, the size of the scatterer SC may refer to a major radius of the ellipse. For example, in some embodiments, where the scatterer SC has a circular shape, the size of the scatterer SC may refer to a diameter of the circle. For instance, in some embodiments, where the scatterer SC has a shape including an uneven protrusion structure, the size of the scatterer SC may refer to a distance between ends spaced apart from each other by a largest distance in the shape of the scatterer SC.

The scatterers SC may most efficiently scatter light having a wavelength band that is twice the size of the scatterer SC.

For example, in some embodiments, where the diameter of the scatterer SC ranges from about 300 nm to about 375 nm, the scatterer SC can efficiently scatter light of a wavelength band ranging from about 600 nm to about 750 nm. In some embodiments, where the diameter of the scatterer SC ranges from about 240 nm to about 280 nm, the scatterer SC can efficiently scatter light of a wavelength band ranging from about 480 nm to about 560 nm. In some embodiments, where the diameter of the scatterer SC ranges from about 185 nm to about 230 nm, the scatterer SC can efficiently scatter light of a wavelength band ranging from about 370 nm to about 460 nm.

Hence, in some embodiments, the size of the first scatterer SC1 may be provided to correspond to the wavelength band of light provided from the second sub-pixel SPX2. The size of the second scatterer SC2 may be provided to correspond to the wavelength band of light provided from the third sub-pixel SPX3.

For example, the first scatterer SC1 may have a size ranging from about 240 nm to about 280 nm. The second scatterer SC2 may have a size ranging from about 185 nm to about 230 nm.

Hence, in some embodiments, the scattering performance of the first scattering layer SCT1 and the second scattering layer SCT2 may be provided (e.g., optimized) for their respective sub-pixels SPX.

Referring to FIG. 10, in some embodiments, the first scatterers SC1 and the second scatterers SC2 may have the same size. The first scatterers SC1 may be contained in the first scattering layer SCT1 at a first weight ratio. The second scatterers SC2 may be contained in the second scattering layer SCT2 at a second weight ratio. The first weight ratio may be greater than the second weight ratio. For example, the number of first scatterers SC1 in the first scattering layer SCT1 may be greater than the number of second scatterers SC2 in the second scattering layer SCT2.

As described above, it may be desirable that the sub-pixels SPX have substantially uniform light output efficiency. It may be suitable for the second sub-pixel SPX2 and the third sub-pixel SPX3 to have light output efficiencies corresponding to (e.g., light output efficiencies that are substantially the same as) each other. For example, light emitted from the light emitting element LD disposed in each of the sub-pixel areas SPXA may include a light element in the second color and a light element in the third color. The light element in the third color may be to form the third sub-pixel SPX3 that provides light in the third color and the first sub-pixel SPX1 that provides light in the first color using the color conversion layer CCL. Therefore, when comparing the second sub-pixel SPX2 to the third sub-pixel SPX3, the third sub-pixel SPX3 may have a higher light output efficiency than the second sub-pixel SPX2. As a result, it may be desirable to compensate for the light output efficiency of the second sub-pixel SPX2 so that the light output efficiencies of the second sub-pixel SPX2 and the third sub-pixel SPX3 can correspond to each other (e.g., can be substantially the same).

The scatterers SC may scatter applied light and enhance the light output efficiency. Hence, as the proportion of scatterers SC included in the scattering layer SCT increases, the light output efficiency of the corresponding sub-pixels SPX may be enhanced.

In some embodiments, the weight ratio of the first scatterers SC1 in the first scattering layer SCT1 may be higher than that of the second scatterers SC2 in the second scattering layer SCT2, thus compensating for a difference in light output efficiency. Hence, the second sub-pixel SPX2 and the third sub-pixel SPX3 may have substantially uniform light output efficiency.

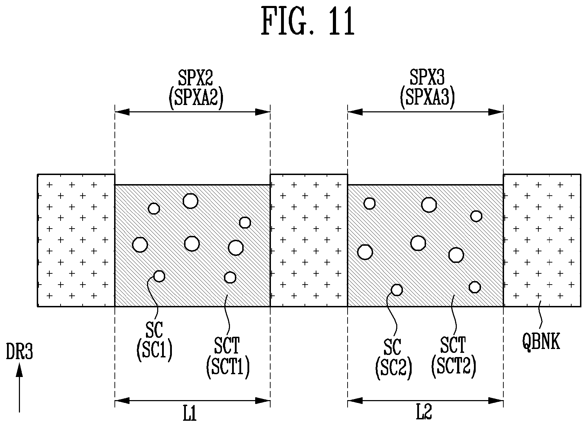

Referring to FIG. 11, in some embodiments, the first scattering layer SCT1 and the second scattering layer SCT2 may be formed through the same process and include materials of the same composition. Furthermore, each of the first scatterers SC1 and the second scatterers SC2 may include some scatterers having different sizes. For example, each of the first scatterers SC1 and the second scatterers SC2 may include scatterers having different sizes at the same composition ratio.

The scatterer SC may relatively efficiently scatter light having a wavelength band that is twice the size of the scatterer SC.

In some embodiments, each of the first scatterers SC1 and the second scatterers SC2 may include both a scatterer having a relatively large size to efficiently scatter light in the second color, and a scatterer having a relatively small size to efficiently scatter light in the third color. Therefore, the first scattering layer SCT1 and the second scattering layer SCT2 may be fabricated through the same process, whereby the process may be simplified, and the light output efficiency for each of the sub-pixels SPX may be improved.

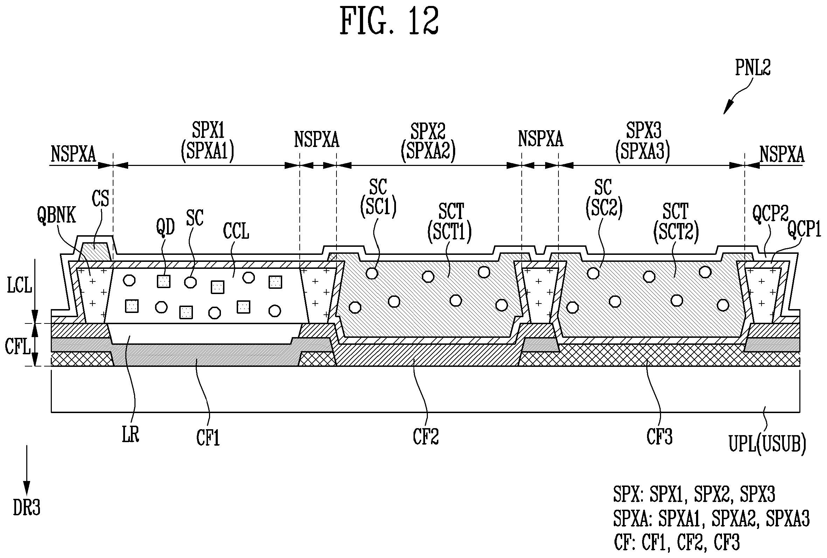

FIGS. 12-15 are sectional views depicting characteristics of the light controlling layer, according to some embodiments of the present disclosure.

For the sake of convenience in explanation, FIGS. 12-15 illustrate the light controlling layer LCL, etc., based on a cross-sectional structure described with reference to FIG. 5. For the sake of convenience in explanation, FIGS. 12-15 illustrate the color filter layer CFL and the light controlling layer LCL that are disposed on the upper substrate USUB. For example, FIGS. 12-15 illustrate the second panel PNL2. To describe the structure in which the second panel PNL2 is formed, a configuration is illustrated where the upper substrate USUB is positioned beneath, and the color filter layer CFL and the light controlling layer LCL are sequentially disposed on the upper substrate USUB.

Referring to FIG. 12, the optical layer LR in some embodiments may be disposed (e.g., selectively disposed) only in some of the sub-pixel areas SPXA.

For example, the optical layer LR may be disposed in the first sub-pixel area SPXA1. The optical layer LR may be disposed neither in the second sub-pixel area SPXA2 nor in the third sub-pixel area SPXA3. Therefore, in some embodiments, the first capping layer QCP1 may be directly adjacent to (e.g., in direct contact with) each of the second and third color filters CF2 and CF3 in the second and third sub-pixel areas SPXA2 and SPXA3.

In some embodiments, the optical layer LR may be a low refractive layer, having a lower refractive index than the color conversion layer CCL. Accordingly, light provided from the color conversion layer CCL may be reflected by the optical layer LR and then supplied back to the color conversion layer CCL, thus forming a light recycling structure.

In some embodiments, the quantum dots QD configured to change the color of light may be disposed in the first sub-pixel area SPXA1 without being disposed in the second and third sub-pixel areas SPXA2 and SPXA3. Therefore, it may be particularly desirable for the light recycling structure to be formed in the first sub-pixel area SPXA1.

Accordingly, in some embodiments, the optical layer LR may be selectively disposed only in some areas, thus leading to a reduction in the processing cost for fabricating the display device DD. Moreover, in the second and third sub-pixel areas SPXA2 and SPXA3 where the optical layer LR is not disposed, the scattering layers SCT may be provided within the thickness range of the optical layer LR. As a result, the scattering performance of the scattering layer SCT in the second and third sub-pixel areas SPXA2 and SPXA3 may be further improved.

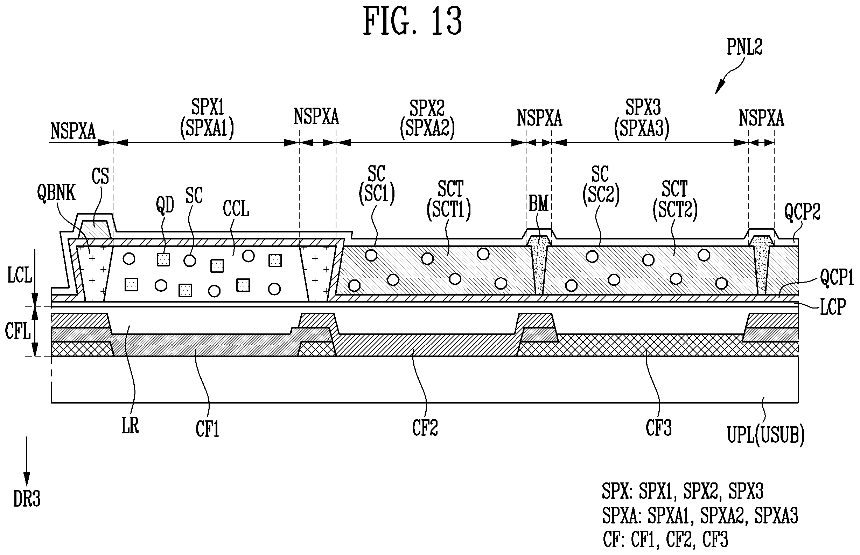

Referring to FIG. 13, the display device DD in some embodiments may further include a black matrix layer BM. In the non-sub-pixel areas NSPXA adjacent to the second and third sub-pixel areas SPXA2 and SPXA3, the black matrix layer BM may be disposed without the presence of the bank QBNK. For example, the black matrix layer BM may be provided, in some embodiments, between the second and third sub-pixel areas SPXA2 and SPXA3 instead of providing a bank QBNK therebetween. The black matrix layer BM may penetrate between the first scattering layer SCT1 and the second scattering layer SCT2.

In some embodiments, the bank QBNK may be patterned in the non-sub-pixel area NSPXA adjacent to the first sub-pixel area SPXA1. The black matrix layer BM may be disposed in the non-sub-pixel area NSPXA that is not directly adjacent to the first sub-pixel area SPXA1. In a plan view, the black matrix layer BM may be disposed in the non-sub-pixel area NSPXA, and may not overlap the sub-pixel areas SPXA. In some embodiments, the black matrix layer BM may be directly adjacent to (e.g., in direct contact with) the first capping layer QCP1. However, the present disclosure is not limited to the aforementioned examples.

In some embodiments, the second scattering layer SCT2 and the third scattering layer SCT3 may be fabricated through the photolithography process rather than the inkjet process. Hence, even in the absence of the bank QBNK adjacent to the second scattering layer SCT2 and the third scattering layer SCT3, the second scattering layer SCT2 and the third scattering layer SCT3 may be suitably patterned.

For example, in some embodiments, to fabricate the first scattering layer SCT1 and the second scattering layer SCT2, a base scattering layer including the scatterers SC may be disposed over the second sub-pixel area SPXA2 and the third sub-pixel area SPXA3. The black matrix layer BM passing through the base scattering layer may be patterned in areas adjacent to the second sub-pixel area SPXA2 and the third sub-pixel area SPXA3.

In some embodiments, the black matrix layer BM may include pigment or dye capable of blocking or absorbing light. For example, the black matrix layer BM may include carbon black or the like. However, the present disclosure is not limited to the aforementioned examples.

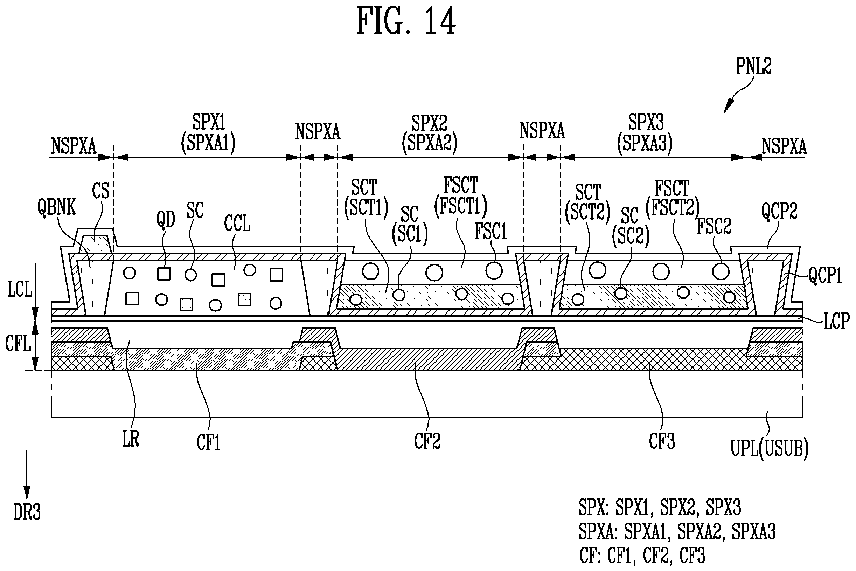

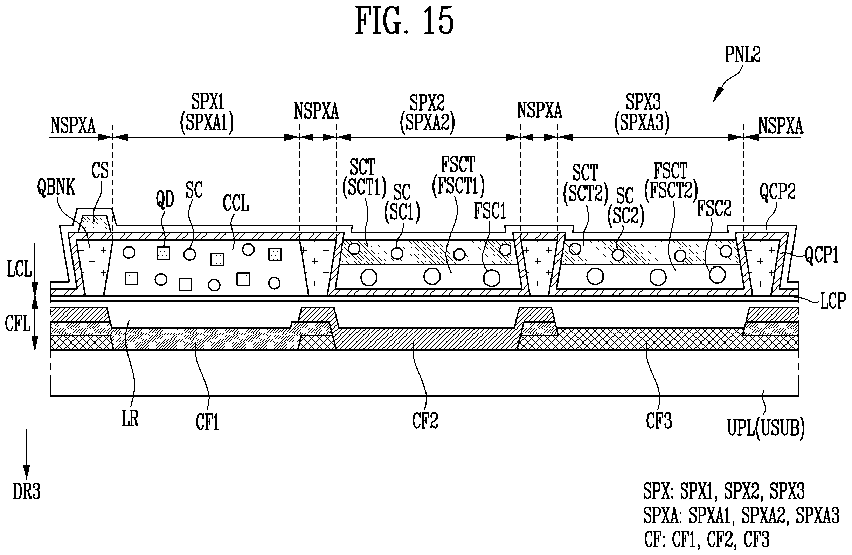

Referring to FIGS. 14 and 15, the display device DD (e.g., the light controlling layer LCL) in some embodiments may further include a filler scattering layer FSCT including filler scatterers FSC. The filler scatterers FSC may include first filler scatterers FSC1 and second filler scatterers FSC2. The filler scattering layer FSCT may include a first filler scattering layer FSCT1 in which the first filler scatterers FSC1 are disposed, and a second filler scattering layer FSCT2 in which the second filler scatterers FSC2 are disposed. The filler scattering layer FSCT may refer to a material including the filler scatterers FSC formed by containing a scattering material in a filler material.

In some embodiments, the first filler scattering layer FSCT1 may be disposed in the second sub-pixel area SPXA2. The first filler scattering layer FSCT1 may overlap the first scattering layer SCT1, in a plan view (e.g., in the third direction DR3). The second filler scattering layer FSCT2 may be disposed in the third sub-pixel area SPXA3. The second filler scattering layer FSCT2 may overlap the second scattering layer SCT2, in a plan view (e.g., in the third direction DR3).

For example (refer to FIG. 14), the first filler scattering layer FSCT1 may be disposed on the first scattering layer SCT1, and may be passivated by (e.g., coated by and/or protected by) the second capping layer QCP2. The second filler scattering layer FSCT2 may be disposed on the second scattering layer SCT2, and may be passivated by the second capping layer QCP2. In some embodiments, after the first scattering layer SCT1 and the second scattering layer SCT2 are patterned, the first filler scattering layer FSCT1 and the second filler scattering layer FSCT2 may be patterned.

In another example (refer to FIG. 15), the first filler scattering layer FSCT1 may be disposed between the first scattering layer SCT1 and the second color filter CF2, and may be adjacent (e.g., directly adjacent) to the first capping layer QCP1 depending on embodiments. The second filler scattering layer FSCT2 may be disposed between the second scattering layer SCT2 and the third color filter CF3, and may be adjacent (e.g., directly adjacent) to the first capping layer QCP1 depending on embodiments. In some embodiments, after the first filler scattering layer FSCT1 and the second filler scattering layer FSCT2 are patterned, the first scattering layer SCT1 and the second scattering layer SCT2 may be patterned.

In some embodiments, a plurality of scattering structures with various scattering characteristics may be formed in the second and third sub-pixel areas SPXA2 and SPXA3, thus leading to enhanced scattering efficiency. Consequently, the light output efficiency of the display device DD may be improved.

FIGS. 16-21 are plan views each depicting an arrangement relationship between the bank and the sub-pixel areas, according to some embodiments of the present disclosure.

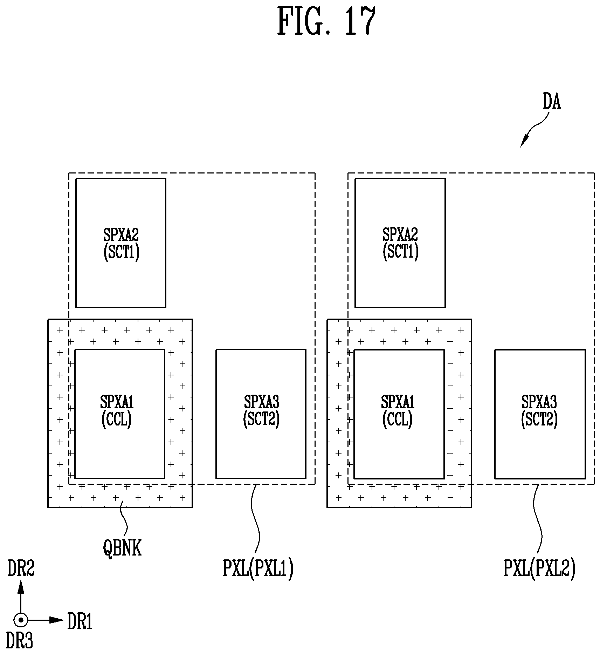

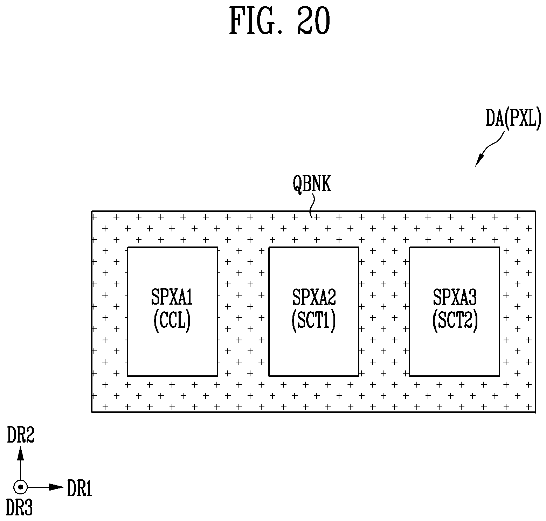

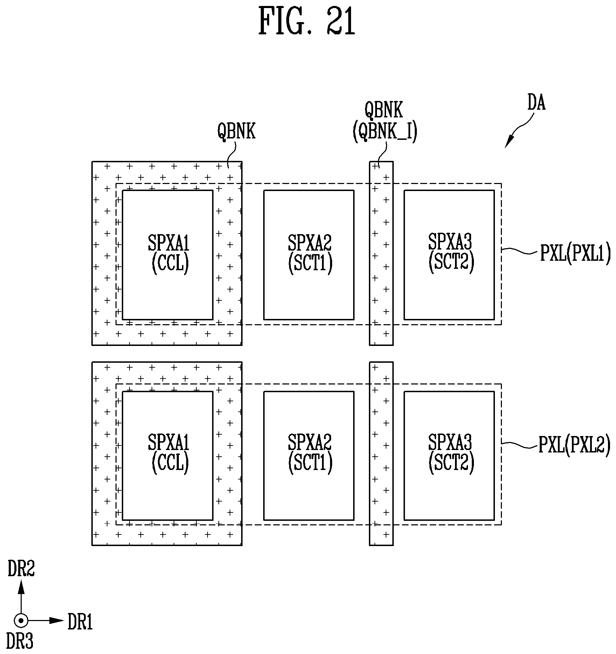

For the sake of convenience in explanation, FIGS. 16-21 illustrate some areas of the display area DA, and illustrate the sub-pixel areas SPXA and the banks QBNK disposed adjacent thereto. FIGS. 16-19 illustrate a structure in which the first sub-pixel area SPXA1 and the second sub-pixel area SPXA2 are adjacent to each other in the second direction DR2, and the third sub-pixel area SPXA3 is adjacent to the first sub-pixel area SPXA1 in the first direction DR1, according to some embodiments of the present disclosure. FIGS. 17-19 illustrate pixels PXL adjacent to each other in the display area DA, according to some embodiments of the present disclosure. For example, FIGS. 17-19 illustrate a first pixel PXL1 and a second pixel PXL2 adjacent to each other in the first direction DR1 among the pixels PXL. FIGS. 20 and 21 illustrate a structure in which the sub-pixel areas SPXA are sequentially disposed in the first direction DR1, according to some embodiments of the present disclosure.

Referring to FIG. 16, the bank QBNK may enclose at least a portion of each of the sub-pixel areas SPXA. FIG. 16 illustrates a pixel PXL in the display area DA, according to some embodiments of the present disclosure.

In some embodiments, the bank QBNK may form a closed-loop for each of the sub-pixel areas SPXA. For example, the bank QBNK may enclose the entirety of (e.g., may surround all sides of) the first sub-pixel area SPXA1 (e.g., the color conversion layer CCL), in a plan view. The bank QBNK may enclose the entirety of the second sub-pixel area SPXA2 (e.g., the first scattering layer SCT1), in a plan view. The bank QBNK may enclose the entirety of the third sub-pixel area SPXA3 (e.g., the second scattering layer SCT2), in a plan view.

Referring to FIG. 17, the bank QBNK may enclose only one of the sub-pixel areas SPXA (e.g., among the three sub-pixel areas SPXA), in a plan view.

In some embodiments, the bank QBNK may enclose the entirety of the first sub-pixel area SPXA1 (e.g., the color conversion layer CCL). Hence, the bank QBNK may form a closed-loop structure, and the inkjet process for fabricating the color conversion layer CCL may be performed.

Furthermore, in some embodiments, the first scattering layer SCT1 and the second scattering layer SCT2 may be fabricated through the photolithography process rather than the inkjet process. Hence, even if the bank QBNK does not directly enclose the second and third sub-pixel areas SPXA2 and SPXA3, the first scattering layer SCT1 and the second scattering layer SCT2 may be appropriately fabricated.

In some embodiments, the second sub-pixel area SPXA2 and the third sub-pixel area SPXA3 that are not directly enclosed by the bank QBNK may be spaced apart from each other by a distance greater than a spacing distance from the first sub-pixel area SPXA1.

For instance, the spacing distance between the second sub-pixel area SPXA2 and the third sub-pixel area SPXA3 may be greater than either the spacing distance between the first sub-pixel area SPXA1 and the third sub-pixel area SPXA3 or the spacing distance between the first sub-pixel area SPXA1 and the second sub-pixel area SPXA2.

Therefore, even if the bank QBNK is not directly adjacent to the second sub-pixel area SPXA2 and the third sub-pixel area SPXA3, the risk of color mixture between the second sub-pixel SPX2 and the third sub-pixel SPX3 can be reduced.

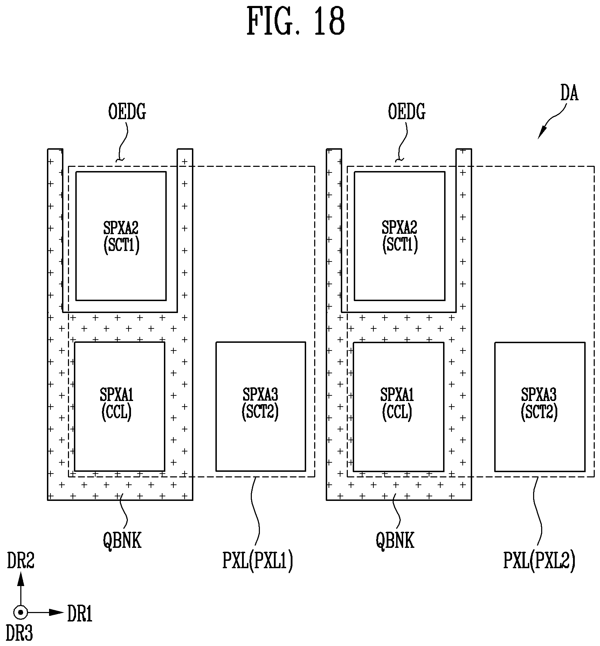

Referring to FIG. 18, in some embodiments, similar to FIG. 17, the bank QBNK may enclose the entirety of the first sub-pixel area SPXA1 (e.g., the color conversion layer CCL) and enclose at least a portion of the second sub-pixel area SPXA2 (e.g., the first scattering layer SCT1), and allows at least another portion of the second sub-pixel area SPXA2 (e.g., the first scattering layer SCT1) to be open. Accordingly, at least one side of the second sub-pixel area SPXA2 may include an open edge OEDG where the bank QBNK is not formed.

In some embodiments, the bank QBNK may be disposed in an area adjacent to the third sub-pixel area SPXA3 (e.g., the second scattering layer SCT2), and may not directly enclose the third sub-pixel area SPXA3 (e.g., the second scattering layer SCT2). Hence, the periphery of the third sub-pixel area SPXA3 may be open.

In some embodiments, the open edge OEDG may be formed toward a direction different from a direction toward the third sub-pixel area SPXA3, based on the second sub-pixel area SPXA2. For example, the open edge OEDG may be formed away from the third sub-pixel area SPXA3, such that the bank QBNK is formed around a second side, of the second sub-pixel area SPXA2, that is closer to the third sub-pixel area SPXA3 than the open edge OEDG is.

For example, the open edge OEDG may be disposed in an upper portion of the second sub-pixel area SPXA2 based on the second direction DR2. The third sub-pixel area SPXA3 may be positioned on a bottom right portion of the second sub-pixel area SPXA2, based on the second direction DR2.

In this case, the risk of color mixture between the second sub-pixel SPX2 and the third sub-pixel SPX3 may be reduced.

In some embodiments, as described above, although the bank QBNK does not directly enclose the third sub-pixel area SPXA3, the bank QBNK may be disposed adjacent to the first and second sub-pixel areas SPXA1 and SPXA2, and thus be substantially adjacent to the third sub-pixel area SPXA3. For example, the third sub-pixel area SPXA3 of the first pixel PXL1 may be positioned between a portion of the bank QBNK of the first pixel PXL1 and a portion of the bank QBNK of the second pixel PXL2.

Accordingly, the spacing distance between the bank QBNK and the second and third sub-pixel areas SPXA2 and SPXA3 may be defined. In some embodiments, the shortest distance between the bank QBNK and the second sub-pixel area SPXA2 may be less than the shortest distance between the bank QBNK and the third sub-pixel areas SPXA3.

Furthermore, in some embodiments, the bank QBNK may enclose areas where the first scattering layer SCT1 and the second scattering layer SCT2 are positioned, each by a different extent. In this case, the respective thicknesses and/or the like of the first scattering layer SCT1 and the second scattering layer SCT2 may be formed to be substantially uniform without a separate additional process. Moreover, the first scattering layer SCT1 and the second scattering layer SCT2 may be patterned based on the photolithography process or the like rather than the inkjet process. Consequently, the uniformity (e.g., thickness uniformity) of the first scattering layer SCT1 and the second scattering layer SCT2 may be enhanced. Furthermore, the process operations may be simplified, thus leading to sufficient process margins and a reduction in processing costs.

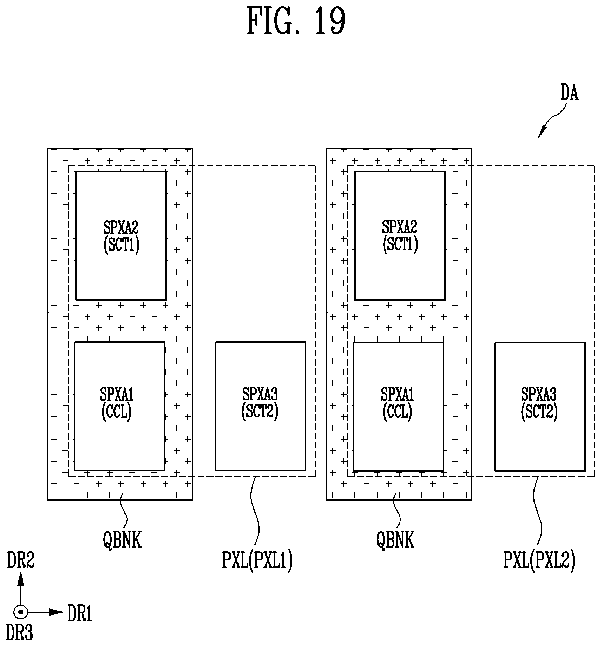

Referring to FIG. 19, in some embodiments, similar to FIG. 18, the bank QBNK may be directly adjacent to the first and second sub-pixel area SPXA2 and be comparatively spaced apart from the third sub-pixel area SPXA3. The bank QBNK may enclose the entirety of the second sub-pixel area SPXA2, in a plan view.

For example, the bank QBNK may form a closed-loop structure enclosing the second sub-pixel area SPXA2.

In this case, when transparent organic material including the scatterers SC is patterned to form the first scattering layer SCT1 and the second scattering layer SCT2, the thickness of the second scattering layer SCT2 may be formed to be less than that of the first scattering layer SCT1. For example, because the first scattering layer SCT1 and the second scattering layer SCT2 include organic material, there may be a phenomenon of diffusion (e.g., spreading) of the first scattering layer SCT1 and the second scattering layer SCT2. In some embodiments, the second sub-pixel area SPXA2 is completely enclosed by the bank QBNK. Hence, the phenomenon of diffusion of the first scattering layer SCT1 may not substantially occur, while some of the second scattering layer SCT2 may diffuse over a relatively large area. Consequently, the second scattering layer SCT2 may be formed with a relatively small thickness, compared to the first scattering layer SCT1.

In some embodiments, as described above, to allow the second sub-pixel SPX2 and the third sub-pixel SPX3 to have a relatively corresponding light output efficiency, it may be suitable for the first scattering layer SCT1 to include a larger amount of scatterers SC compared to the second scattering layer SCT2. In some embodiments, because the second scattering layer SCT2 may be formed with a relatively small thickness compared to the first scattering layer SCT1, the second scattering layer SCT2 may include a relatively large amount of scatterers SC compared to the first scattering layer SCT1. Therefore, according to the structure of the bank QBNK in some embodiments, the second sub-pixel SPX2 and the third sub-pixel SPX3 may be provided to have relatively corresponding light output efficiency (e.g., to have substantially the same light output efficiency).

Referring to FIGS. 20 and 21, the first sub-pixel area SPXA1, the second sub-pixel area SPXA2, and the third sub-pixel area SPXA3 may be sequentially arranged in the first direction DR1. The bank QBNK may enclose at least some portions of the sub-pixel areas SPXA.

For example (refer to FIG. 20), the bank QBNK may form a closed-loop structure enclosing each of the first sub-pixel area SPXA1, the second sub-pixel area SPXA2, and the third sub-pixel area SPXA3.

In another example (refer to FIG. 21), the bank QBNK may enclose the entirety of the first sub-pixel area SPXA1, and may allow at least a portion of each of the second and third sub-pixel areas SPXA2 and SPXA3 to be open. For example, the bank QBNK may not be disposed on at least one side of each of the second and third sub-pixel areas SPXA2 and SPXA3.

In some embodiments, the bank QBNK may include an isolated bank component QBNK_I. The isolated bank component QBNK_I may be a part of the bank QBNK, and may be a part separated from other banks QBNK. The isolated bank component QBNK_I may be positioned between the second sub-pixel area SPXA2 and the third sub-pixel area SPXA3.

In some embodiments, the isolated bank component QBNK_I may extend in a direction (e.g., the second direction DR2) different from a direction in which the second sub-pixel area SPXA2 and the third sub-pixel area SPXA3 are spaced apart from each other.

In some embodiments, the first scatter SCT1 and the second scatter SCT2 may not be fabricated through the inkjet process. Hence, the bank QBNK may allow one side of each of the second sub-pixel area SPXA2 and the third sub-pixel area SPXA3 to be open.

In some embodiments, an area where the bank QBNK is disposed may be minimized, thus leading to a reduction in processing costs. Moreover, the first scattering layer SCT1 and the second scattering layer SCT2 may be patterned based on the photolithography process or the like rather than the inkjet process. Consequently, the uniformity (e.g., thickness uniformity) of the first scattering layer SCT1 and the second scattering layer SCT2 may be enhanced.

In some embodiments, the isolated bank component QBNK_I that is a part of the bank QBNK may be disposed (e.g., selectively disposed) between the second sub-pixel area SPXA2 and the third sub-pixel area SPXA3. Hence, the risk of color mixture between the second sub-pixel SPX2 and the third sub-pixel SPX3 can be reduced.

In some embodiments, the isolated bank component QBNK_I that is a part of the bank QBNK may not be disposed between the first pixel PXL1 and the second pixel PXL2 spaced apart from each other by a relatively large distance (e.g., between the second and third sub-pixel areas SPXA2 and SPXA3 of the first pixel PXL1 and the second and third sub-pixel areas SPXA2 and SPXA3 of the second pixel PXL2). In other words, the isolated bank component QBNK_I may not be disposed in areas with relatively low color mixture risk, thus resulting in a reduction in the cost of process materials.

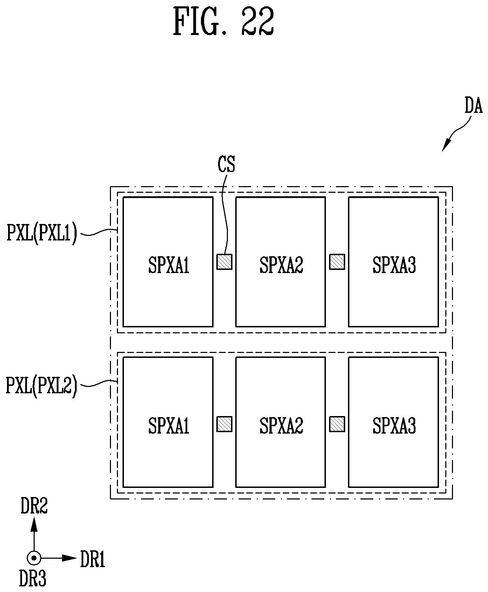

FIGS. 22-26 are plan views each depicting an arrangement relationship between the spacer and the sub-pixel areas, according to some embodiments of the present disclosure.

For the sake of convenience in explanation, FIGS. 22-26 illustrate some areas of the display area DA, and illustrate the sub-pixel areas SPXA and the spacers CS disposed adjacent thereto.

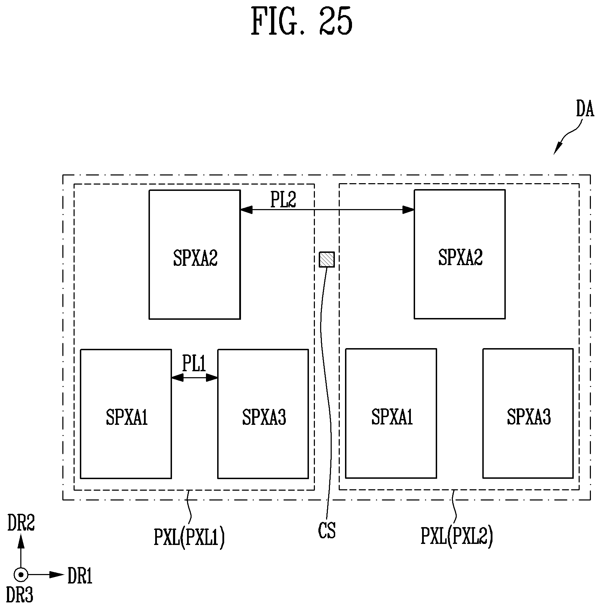

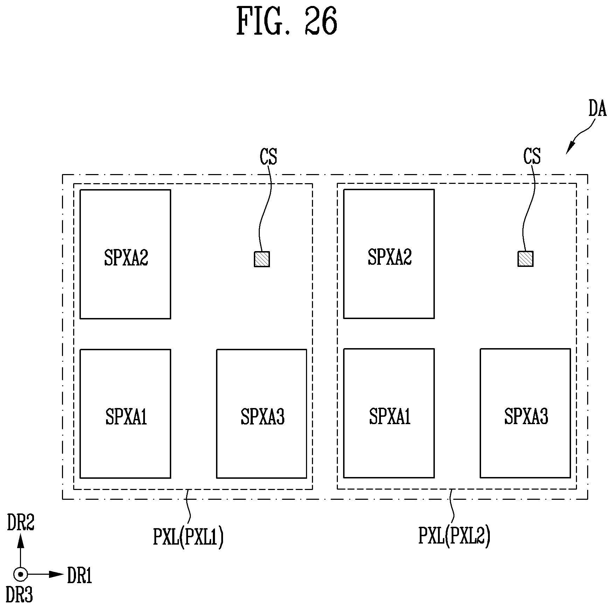

FIGS. 22-24 illustrate a planar structure in which the sub-pixel areas SPXA are sequentially arranged in the first direction DR1. For the sake of convenience in explanation, FIGS. 22-24 illustrate a planar structure in which the first pixel PXL1 and the second pixel PXL2 are adjacent to each other in the second direction DR2. FIGS. 25 and 26 illustrate a planar structure in which the first sub-pixel area SPXA1 and the third sub-pixel area SPXA3 are adjacent to each other in the first direction DR1, and the second sub-pixel area SPXA2 is spaced apart from the first sub-pixel area SPXA1 and the third sub-pixel area SPXA3 in the second direction DR2. For the sake of convenience in explanation, FIGS. 25 and 26 illustrate a planar structure in which the first pixel PXL1 and the second pixel PXL2 are adjacent to each other in the first direction DR1, according to some embodiments of the present disclosure.

Referring to FIGS. 22-24, the spacers CS may be disposed in an area where the sub-pixel areas SPXA are not formed (e.g., the non-sub-pixel area NSPXA). The spacers CS may be disposed to be adjacent between the sub-pixel areas SPXA.

In some embodiments (refer to FIG. 22), the spacers CS may be positioned between the sub-pixel areas SPXA based on the first direction DR1. For example, the spacer CS may be disposed between the first sub-pixel area SPXA1 and the second sub-pixel area SPXA2. The spacer CS may be positioned between the second sub-pixel area SPXA2 and the third sub-pixel area SPXA3. The spacer CS may be positioned between the first sub-pixel area SPXA1 and the third sub-pixel area SPXA3. Therefore, the spacers CS may be sequentially arranged in the first direction DR1, and may be sequentially arranged in the second direction DR2.

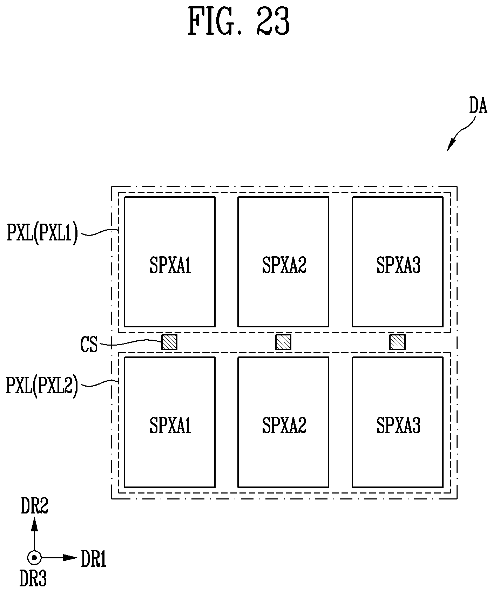

In some embodiments (refer to FIG. 23), the spacers CS may be positioned between the sub-pixel areas SPXA based on the second direction DR2. The spacers CS may be disposed between different pixels PXL adjacent to each other in the second direction DR2. For example, the spacer CS may be disposed between the first sub-pixel area SPXA1 of the first pixel PXL1 and the first sub-pixel area SPXA1 of the second pixel PXL2. The spacer CS may be disposed between the second sub-pixel area SPXA2 of the first pixel PXL1 and the second sub-pixel area SPXA2 of the second pixel PXL2. The spacer CS may be disposed between the third sub-pixel area SPXA3 of the first pixel PXL1 and the third sub-pixel area SPXA3 of the second pixel PXL2.

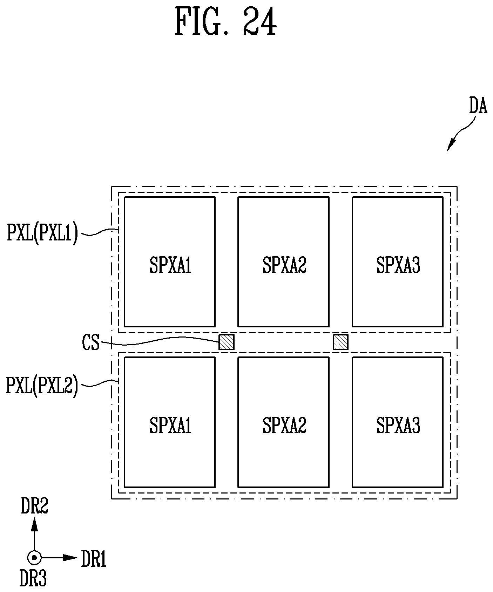

In some embodiments (refer to FIG. 24), the spacers CS may not overlap the sub-pixel areas SPXA in the first direction DR1 or the second direction DR2. For example, the spacer CS may be disposed between the first pixel PXL1 and the second pixel PXL2 in the first direction DR1, and may not overlap the sub-pixel areas SPXA in the second direction DR2.

Referring to FIGS. 25 and 26, the spacer CS may be disposed in a relatively large area among the areas where the sub-pixel areas SPXA are not disposed. In some embodiments, the spacer CS may be disposed in a relatively large area where the sub-pixel areas SPXA are not formed, as a portion of the area where the pixel PXL is formed. Consequently, the display area DA may be more efficiently utilized.

In some embodiments (refer to FIG. 25), the spacer CS may be disposed between different pixels PXL. For example, the spacer CS may be disposed between the second sub-pixel area SPXA2 of the first pixel PXL1 and the second sub-pixel area SPXA2 of the second pixel PXL2, with respect to the first direction DR1. The spacer CS may not overlap the sub-pixel areas SPXA in a direction (e.g., the second direction DR2) different from a direction in which the first pixel PXL1 and the second pixel PXL2 are spaced apart from each other.

In some embodiments, the respective sub-pixel areas SPXA may be spaced apart from each other by a certain distance. Here, the spacer CS may be disposed between the sub-pixel areas SPXA that are spaced apart from each other by a relatively large distance. For example, in a single pixel PXL, the first sub-pixel area SPXA1 and the second sub-pixel area SPXA2 may be spaced apart from each other by a first spacing distance PL1. The second sub-pixel area SPXA2 of the first pixel PXL1 and the second sub-pixel area SPXA2 of the second pixel PXL2 may be spaced apart from each other by a second spacing distance PL2 greater than the first spacing distance PL1. In some embodiments, the second spacing distance PL2 may be the largest spacing distance among the spacing distances defined between the sub-pixel areas SPXA in the display area DA. In some embodiments, the spacer CS may be disposed in an area where the second spacing distance PL2 is defined.

In some embodiments (refer to FIG. 26), the spacer CS may be positioned between the respective second sub-pixel areas SPXA2 of different pixels PXL in the first direction DR1. For example, the spacer CS may overlap the second sub-pixel area SPXA2 of the first pixel PXL1 and the second sub-pixel area SPXA2 of the second pixel PXL2, with respect to the first direction DR1. For example, the spacers CS and the second sub-pixel areas SPXA2 may be alternately arranged in the first direction DR1.

In some embodiments, the spacer CS may overlap the third sub-pixel area SPXA3 in the second direction DR2. Hence, the spacer CS may not overlap the first sub-pixel area SPXA1 in each of the first direction DR1 and the second direction DR2.

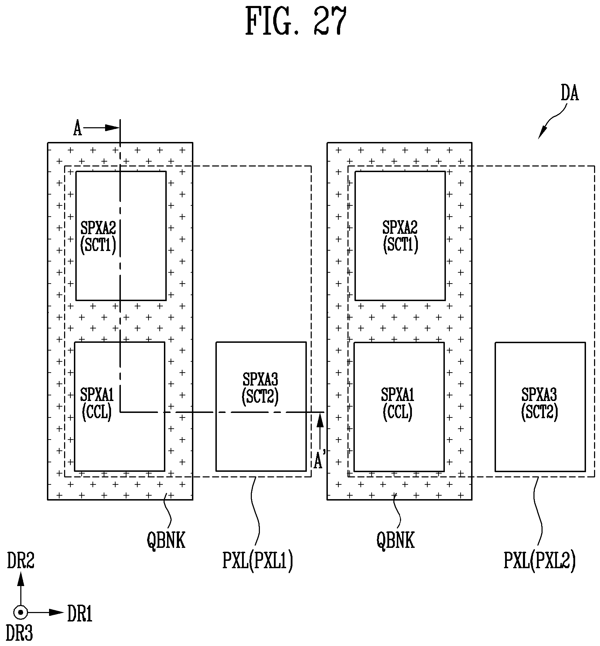

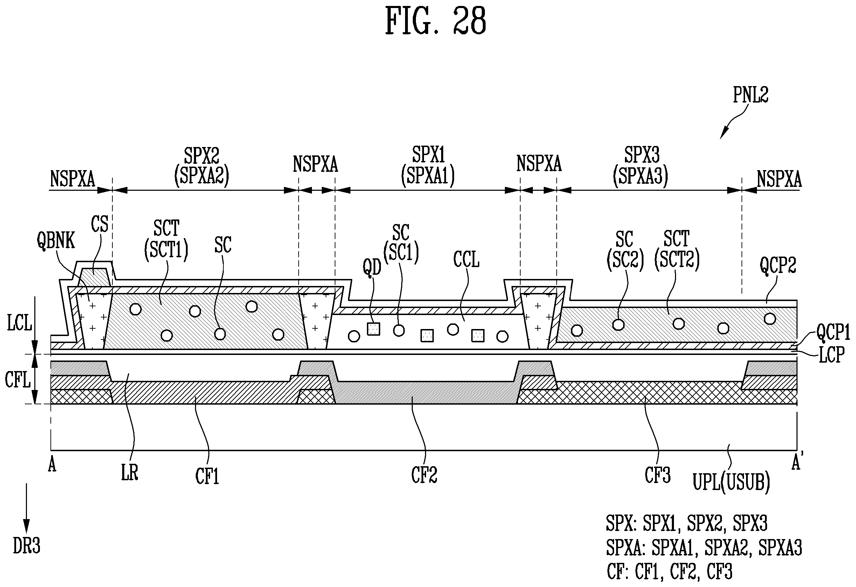

In some embodiments, (e.g., see FIGS. 27 and 28), the color conversion layer CCL and the first scattering layer SCT1 may be fabricated through an inkjet process, and the second scattering layer SCT2 may be fabricated through a photolithography using a mask.

FIG. 27 is a schematic plan view illustrating the display area of the display device in some embodiments. FIG. 28 is a schematic sectional view taken along line A-A' of FIG. 27, showing a schematic sectional view of the second panel, according to some embodiments of the present disclosure. For the sake of convenience in explanation, FIG. 28 illustrates an embodiment in which the light controlling layer LCL is included in the second panel PNL2, and illustrates a structure in which the color filter layer CFL and the light controlling layer LCL are disposed on the upper substrate USUB.

Referring to FIGS. 27 and 28, the bank QBNK may form a closed-loop structure enclosing each of the first sub-pixel area SPXA1 and the second sub-pixel area SPXA2. Hence, the color conversion layer CCL and the first scattering layer SCT1 may be fabricated through an inkjet process.

In some embodiments, after the color conversion layer CCL and the first scattering layer SCT1 are fabricated through the inkjet process, the first capping layer QCP1 may be fabricated. After the first capping layer QCP1 is disposed, the second scattering layer SCT2 may be patterned. Accordingly, the first capping layer QCP1 may passivate the color conversion layer CCL and the first scattering layer SCT1. The second scattering layer SCT2 may be disposed on the first capping layer QCP1.

In some embodiments, as similarly discussed above, the bank QBNK allows at least some portions of sides of the third sub-pixel area SPXA3 to be open when viewed in a plan view. Therefore, the second scattering layer SCT2 patterned in the third sub-pixel area SPXA3 or the like may expand (e.g., spread) beyond the area where the third sub-pixel area SPXA3 is defined. Consequently, the second scattering layer SCT2 may be designed to have a relatively small thickness compared to the first scattering layer SCT1.

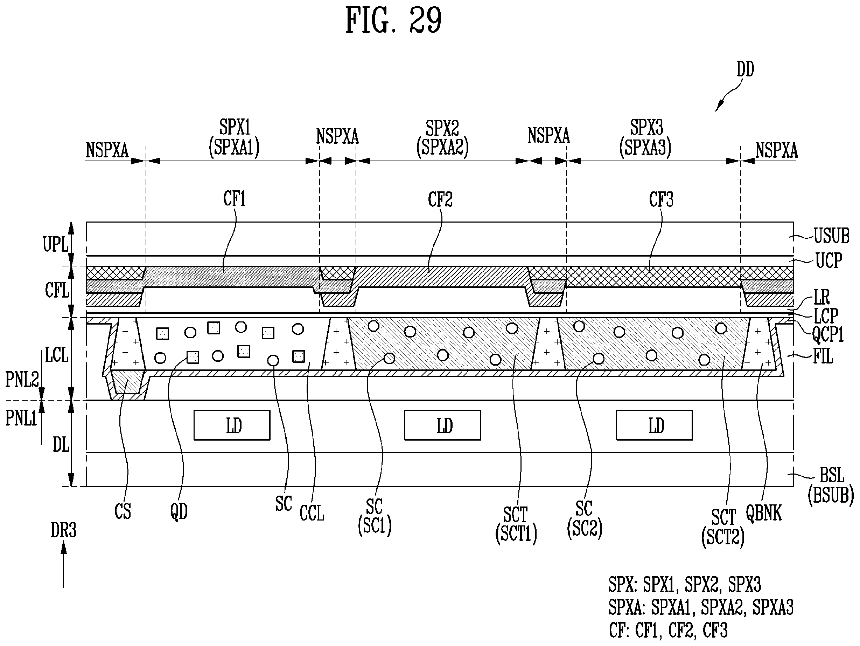

Next, a display device DD in some embodiments will be described with reference to FIGS. 29-31. Description overlapping that of the contents described above will be simplified, or may not be repeated. For example, technical characteristics described with reference to FIGS. 5-28, unless inconsistent with characteristics discussed in embodiments to be described below, may be applied to the display device DD in accordance with the embodiments to be described with reference to FIGS. 29-31.

The display device DD in accordance with embodiments illustrated in FIGS. 29-31 is different from the display device DD in accordance with the aforementioned embodiments in that the color conversion layer CCL, the first scattering layer SCT1, and the second scattering layer SCT2 are fabricated through a photolithography process.

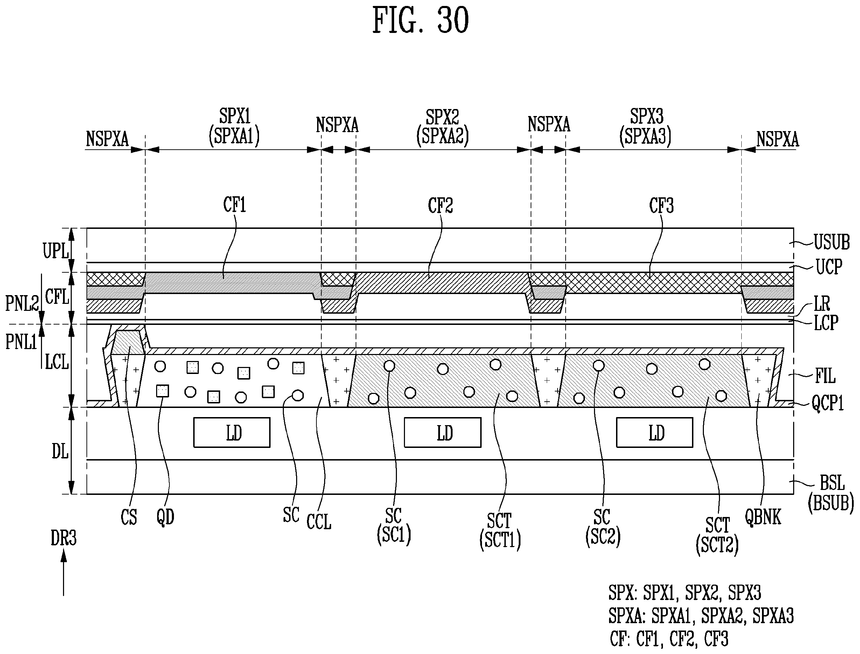

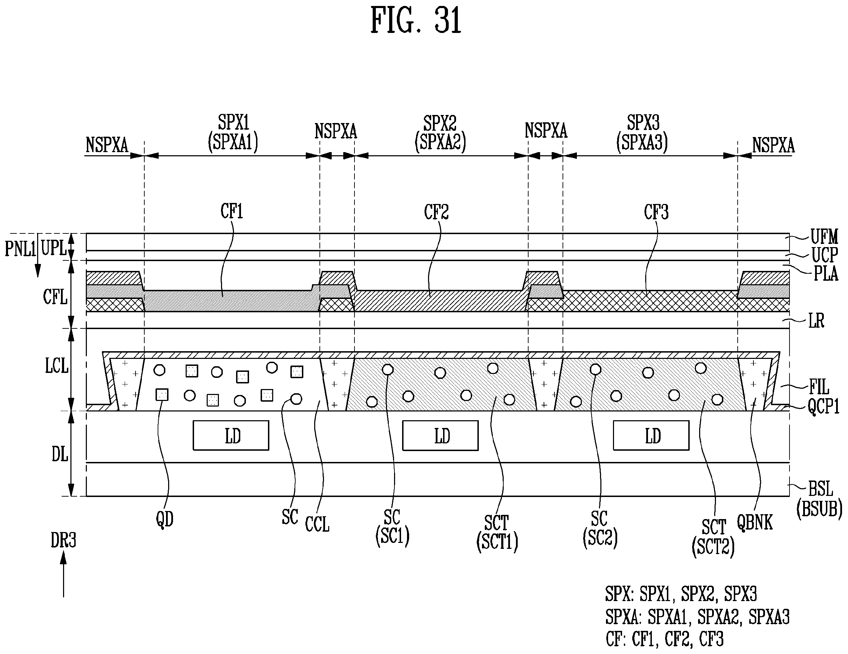

FIGS. 29-31 are schematic sectional views each illustrating the display device DD according to some embodiments of the present disclosure. In some embodiments, FIG. 29 illustrates a planar structure of a display device DD similar to that of the embodiment of FIG. 5 described above. FIG. 30 illustrates a planar structure of a display device DD similar to that of the embodiment of FIG. 6 described above. FIG. 31 illustrates a planar structure of a display device DD similar to that of the embodiment of FIG. 7 described above.

In some embodiments, the color conversion layer CCL, the first scattering layer SCT1, and the second scattering layer SCT2 may be fabricated without performing a separate inkjet process. Hence, after the color conversion layer CCL, the first scattering layer SCT1, and the second scattering layer SCT2 are fabricated, the first capping layer QCP1 may be disposed. The first capping layer QCP1 may passivate each of the bank QBNK, the color conversion layer CCL, the first scattering layer SCT1, and the second scattering layer SCT2.

In some embodiments, after the color conversion layer CCL is patterned, the first scattering layer SCT1 and the second scattering layer SCT2 may be patterned. In some embodiments, after the first scattering layer SCT1 and the second scattering layer SCT2 are patterned, the color conversion layer CCL may be patterned. In some embodiments, the first scattering layer SCT1 and the second scattering layer SCT2 may have similar thicknesses (e.g., substantially the same thickness).

In some embodiments (refer to FIG. 29), the light controlling layer LCL may be disposed to be included in the second panel PNL2. For example, the light controlling layer LCL may be disposed on the color filter layer CFL disposed on the upper substrate USUB.

In some embodiments (refer to FIG. 30), the light controlling layer LCL may be disposed to be included in the first panel PNL1. For example, the light controlling layer LCL may be on the display layer DL disposed on the lower substrate BSUB.

In some embodiments (refer to FIGS. 29 and 30), the spacer CS may be patterned through the same process as the first scattering layer SCT1 and the second scattering layer SCT2, and may include the same material. In some embodiments, the spacer CS may be passivated by the first capping layer QCP1.

In some embodiments (refer to FIG. 31), the first panel PNL may be fabricated by sequentially placing the display layer DL, the light controlling layer LCL, the optical layer LR, the color filter layer CFL, the planarization layer PLA, and the upper layer UPL on the lower substrate BSUB without fabricating a separate second panel PNL2. The display device DD may be fabricated without performing a separate process of coupling the panels to each other. In this case, when the first scattering layer SCT1 and the second scattering layer SCT2 may be patterned, the spacer CS may not be formed.

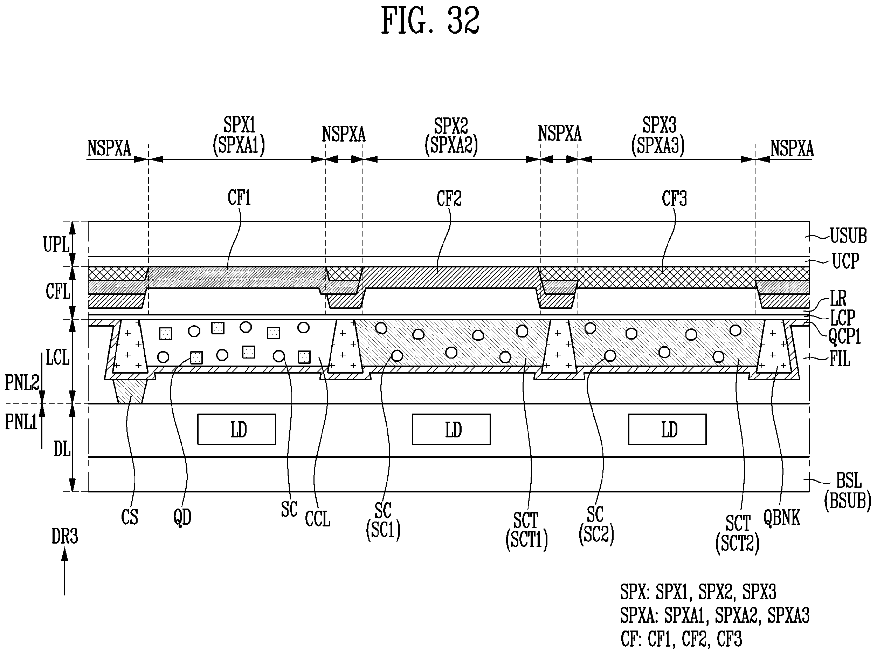

Next, a display device DD according to some embodiments will be described with reference to FIGS. 32-35. Description overlapping that of the contents described above will be simplified, or may not be repeated. For example, technical characteristics described with reference to FIGS. 5-31, unless inconsistent with characteristics discussed in embodiments to be described below, may be applied to the display device DD in accordance with the embodiments to be described with reference to FIGS. 32-35.

The display device DD in accordance with embodiments illustrated in FIGS. 32-35 is different from the display device DD in accordance with the aforementioned embodiments in that the color conversion layer CCL, the first scattering layer SCT1, and the second scattering layer SCT2 are fabricated through an inkjet process.

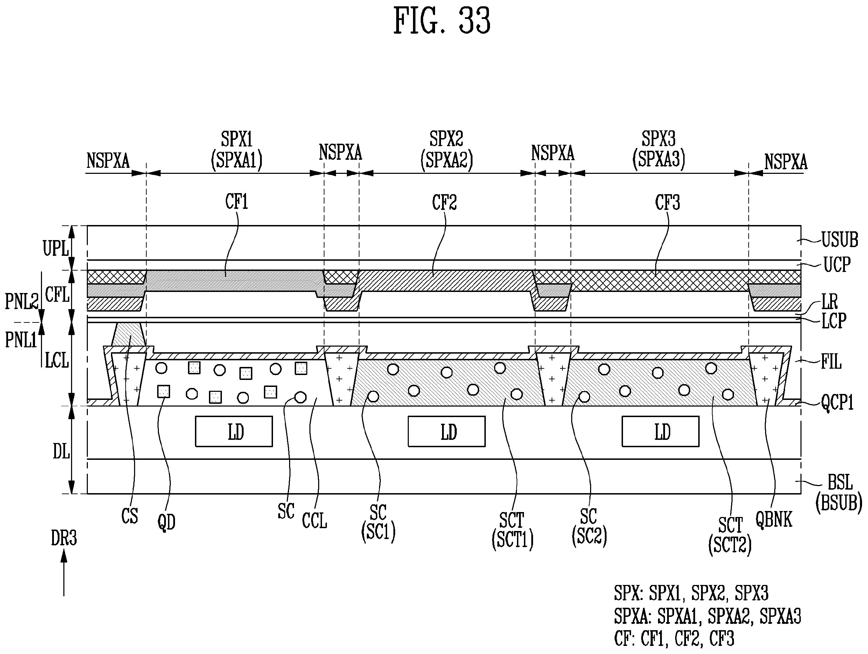

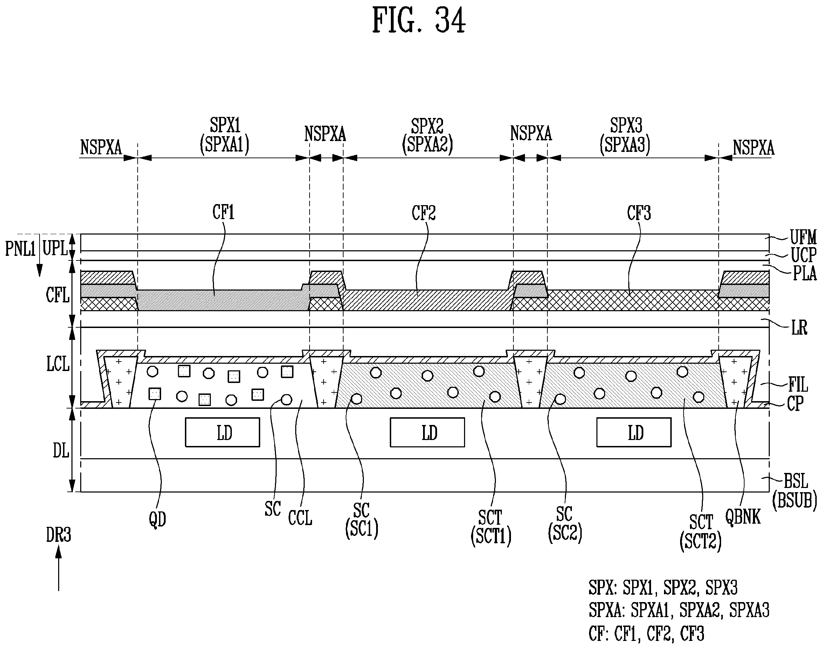

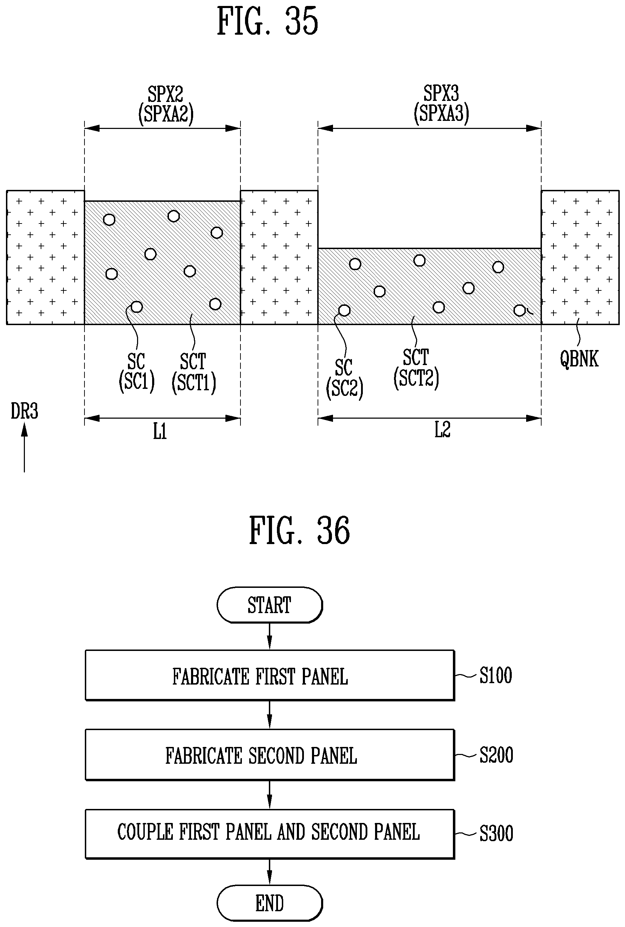

FIGS. 32-34 are schematic sectional views each illustrating a display device, according to some embodiments of the present disclosure. FIG. 35 is a schematic sectional view depicting a relationship between the first scattering layer and the second scattering layer, according to some embodiments of the present disclosure. In some embodiments, FIG. 32 illustrates a planar structure of the display device DD similar to that of the embodiment of FIG. 5 described above. FIG. 33 illustrates a planar structure of a display device DD similar to that of the embodiment of FIG. 8 described above. FIG. 34 illustrates a planar structure of a display device DD similar to that of the embodiment of FIG. 7 described above. FIG. 35 illustrates the second sub-pixel area SPXA2, the third sub-pixel area SPXA3, and the banks QBNK adjacent thereto.

In some embodiments, the color conversion layer CCL, the first scattering layer SCT1, and the second scattering layer SCT2 may be fabricated without performing a separate photolithography process. Consequently, each of the color conversion layer CCL, the first scattering layer SCT1, and the second scattering layer SCT2 may be fabricated through an inkjet process. In some embodiments, the inkjet process of forming each of the color conversion layer CCL, the first scattering layer SCT1, and the second scattering layer SCT2 may be performed in an area enclosed by the bank QBNK. Thereafter, the first capping layer QCP1 may passivate the color conversion layer CCL, the first scattering layer SCT1, and the second scattering layer SCT2.

In some embodiments, after the inkjet process of forming the color conversion layer CCL is performed, the inkjet process of forming the first scattering layer SCT1 and the second scattering layer SCT2 may be performed. In some embodiments, after the inkjet process of forming the first scattering layer SCT1 and the second scattering layer SCT2 is performed, the inkjet process of forming the color conversion layer CCL may be performed.

In some embodiments (refer to FIG. 32), the light controlling layer LCL may be disposed to be included in the second panel PNL2. For example, the light controlling layer LCL may be on the color filter layer CFL disposed on the upper substrate USUB.

In some embodiments (refer to FIG. 33), the light controlling layer LCL may be disposed to be included in the first panel PNL1. For example, the light controlling layer LCL may be on the display layer DL disposed on the lower substrate BSUB.

In some embodiments (refer to FIGS. 32 and 33), the spacer CS may be patterned in the non-sub-pixel area NSPXA (e.g., through a photolithography process) after the color conversion layer CCL, the first scattering layer SCT1, and the second scattering layer SCT2 are fabricated (e.g., after the first capping layer QCP1 is fabricated).

In some embodiments (refer to FIG. 34), the first panel PNL may be fabricated by sequentially placing the display layer DL, the light controlling layer LCL, the optical layer LR, the color filter layer CFL, the planarization layer PLA, and the upper layer UPL on the lower substrate BSUB without fabricating a separate second panel PNL2. The display device DD may be fabricated without performing a separate process of coupling the panels to each other. In this case, after the inkjet process for the first scattering layer SCT1 and the second scattering layer SCT2 is performed, the process of forming the spacer CS may not be performed.

In some embodiments, (refer to FIG. 35) a first distance L1 that is a spacing distance between the banks QBNK1 (e.g., first bank parts) defining the second sub-pixel area SPXA2 may be less than a second distance L2 that is a spacing distance between the banks QBNK1 (e.g., second bank parts) defining the third sub-pixel area SPXA3. For example, the first distance L1 may correspond to a distance between a first bank part and a second bank part, while the second distance L2 may correspond to a distance between a third bank part and the second bank part.

For example, the first distance L1 may be the shortest distance between the banks QBNK adjacent (e.g., directly adjacent) to the second sub-pixel area SPXA2 (or the first scattering layer SCT1). The second distance L2 may be the shortest distance between the banks QBNK adjacent (e.g., directly adjacent) to the third sub-pixel area SPXA3 (or the second scattering layer SCT2).

In some embodiments, the first scattering layer SCT1 and the second scattering layer SCT2 may be formed through the same inkjet process, and may include materials of the same composition. Furthermore, the bank QBNK may be patterned such that the first distance L1 is less than the second distance L2, thus allowing the first scattering layer SCT1 to have a thickness greater than the second scattering layer SCT2.

Experimentally, the scattering efficiency in each of the first scattering layer SCT1 and the second scattering layer SCT2 may generally increase as the thickness of each of the first scattering layer SCT1 and the second scattering layer SCT2 increases.

As described above, it may be desirable for the second sub-pixel SPX2 and the third sub-pixel SPX3 to have corresponding light output efficiencies. Hence, the first scattering layer SCT1 may be fabricated to have a thickness greater than the second scattering layer SCT2. In this case, due to a relatively large thickness of the first scattering layer SCT1, even if the light efficiency for the second color is relatively low, a difference in light output efficiency between the second sub-pixel SPX2 and the third sub-pixel SPX3 may be compensated for. As a result, the second sub-pixel SPX2 and the third sub-pixel SPX3 may have relatively similar light output efficiencies.

In some embodiments, the respective processes of fabricating the first scattering layer SCT1 and the second scattering layer SCT2 may not be separately performed. In other words, the first scattering layer SCT1 and the second scattering layer SCT2 may be fabricated through the same inkjet process. In some embodiments, because the first distance L1 is less than the second distance L2, the space where the first scattering layer SCT1 defined by the enclosure of the bank QBNK is placed may be smaller than the space where the second scattering layer SCT2 defined by the enclosure of the bank QBNK is placed. In this case, even if the volume of ink drops including the scatterers SC, provided to each of the areas, is not separately adjusted during an inkjet process, the thicknesses of ink supplied to the second sub-pixel area SPXA2 and the third sub-pixel area SPXA3 may be defined to different values.

Consequently, in some embodiments, the process convenience may be improved, and a difference in light output efficiency between the sub-pixels SPX may be compensated for. As a result, the display device DD may be fabricated to have uniform light output efficiency for each of the sub-pixels SPX.

A method of fabricating the display device DD according to some embodiments is discussed below with reference to FIGS. 36-49. Description overlapping that of the contents described above will be simplified, or may not be repeated.

FIGS. 36-43 illustrate operations of methods of fabricating the display device DD in such a way that the first panel PNL1 and the second panel PNL2 are separately provided and then coupled to each other, wherein the light controlling layer LCL is included in the second panel PNL2, according to some embodiments of the present disclosure.

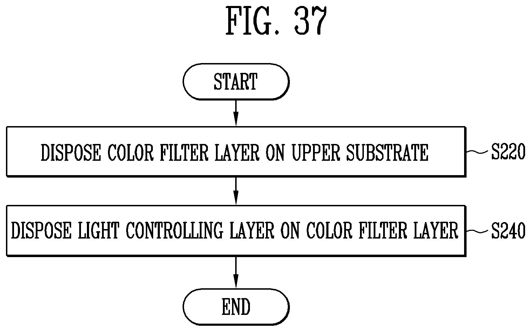

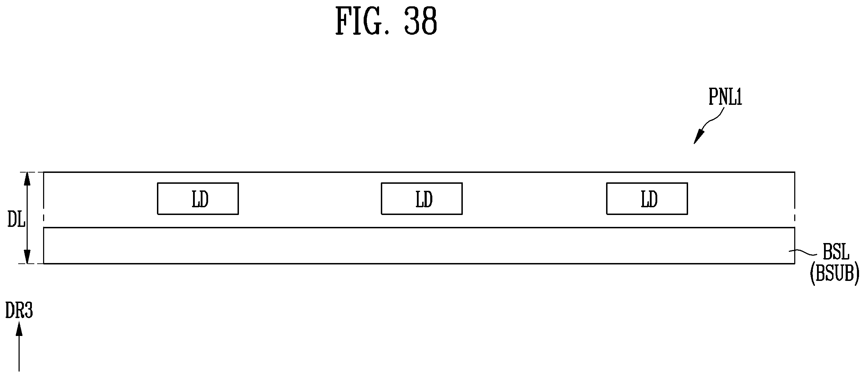

FIG. 36 is a flowchart illustrating a method of fabricating the display device, according to some embodiments of the present disclosure. FIG. 37 is a flowchart illustrating sub-operations of the operation of fabricating the second panel, according to some embodiments of the present disclosure. FIGS. 38-43 are schematic sectional views illustrating, by process operations, the method of fabricating the display device, according to some embodiments of the present disclosure.

The method of fabricating the display device DD according to some embodiments may include operation S100 of fabricating the first panel, operation S200 of fabricating the second panel, and operation S300 of coupling the first panel and the second panel to each other.

In some embodiments, after operation S100 of fabricating the first panel is performed, operation S200 of fabricating the second panel may be performed. In some examples, after operation S200 of fabricating the second panel is performed, operation S100 of fabricating the first panel may be performed. As a further alternative, operation S100 of fabricating the first panel and operation S200 of fabricating the second panel may be performed in substantially the same time period. For the sake of convenience in explanation, the method of fabricating the display device DD will be described, based on an embodiment in which after operation S100 of fabricating the first panel is performed, operation S200 of fabricating the second panel is performed.

Referring to FIGS. 36-38, at operation S100 of fabricating the first panel, the first panel PNL1, the first panel PNL1 including the display layer DL may be provided.

At operation S100, layers forming the display layer DL may be disposed on the lower substrate BSUB forming the base layer BSL.

In some embodiments, a conductive layer or an insulating layer on the lower substrate BSUB or the upper substrate USUB may be formed based on a process for fabricating a semiconductor device. For example, the conductive layers or the insulating layers on the base layer BSL may be formed through a photolithography process, may be etched by various methods (e.g., wet etching, dry etching, and/or the like) and may be deposited by various methods (e.g., sputtering, chemical vapor deposition, or the like). However, the present disclosure is not limited to a specific example.

At operation S100, the pixel circuit layer PCL may be formed by patterning the pixel circuit PXC on the lower substrate BSUB, and the light emitting elements LD may be disposed on the pixel circuit layer PCL. In some embodiments, at operation S100, the light emitting elements LD may be disposed on the lower substrate BSUB (e.g., the pixel circuit layer PCL) by various methods.

For example, referring to FIG. 3, each light emitting element LD may include an organic light emitting diode. The light emitting element LD may be fabricated on the lower substrate BSUB through a deposition process.

In some embodiments, each light emitting element LD may include an inorganic light emitting diode. Element ink including light emitting elements LD may be supplied onto the lower substrate BSUB. Alignment signals may be respectively supplied to a first alignment electrode and a second alignment electrode to form an electric field, whereby the light emitting elements LD may be aligned between the first alignment electrode and the second alignment electrode, based on the formed electric field.

In some embodiments, each light emitting element LD may include an inorganic light emitting diode. The light emitting elements LD may be transferred onto the pixel circuit layer PCL by various methods.

Referring to FIG. 36, operation S200 of fabricating the second panel may be performed. In some embodiments, referring to FIG. 37, operation S200 of fabricating the second panel may include operation S220 of placing the color filter layer on the upper substrate, and operation S240 of placing the light controlling layer on the color filter layer.

Referring to FIGS. 36, 37, and 39, at operation S220 of placing the color filter layer on the upper substrate, the color filters CF may be patterned (e.g., successively patterned) on the upper substrate USUB, and the optical layer LR and the optical capping layer LCP may be on the color filters CF.

At operation S220, the third color filter CF3, the second color filter CF2, and the first color filter CF1 may be disposed on the upper substrate USUB. The color filters CF may be formed through various processes such as a photolithography process. In some embodiments, the sequence of forming the color filters CF is not particularly limited.

At operation S220, the optical layer LR may be formed (e.g., deposited) to cover the color filters CF. In some embodiments, as described above, the optical layer LR may be selectively disposed in the first sub-pixel area SPXA1.

At operation S220, the optical capping layer LCP may cover the optical layer LR to passivate the optical layer LR.

Referring to FIGS. 36, 37, and 39-42, at operation S240 of disposing the light controlling layer on the color filter layer, the components for forming the light controlling layer LCL may be disposed on the color filter layer CFL.

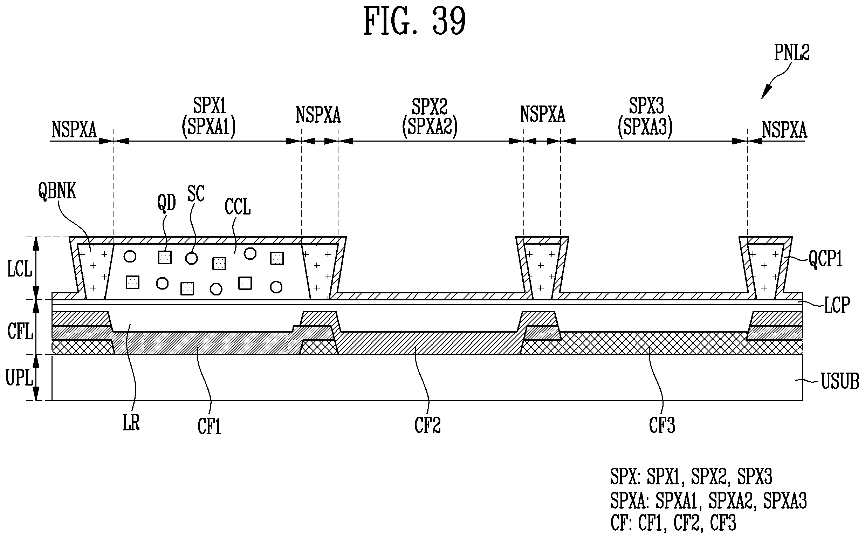

Referring to FIG. 39, at operation S240, the bank QBNK may be patterned on the color filter layer CFL. The bank QBNK may be disposed to enclose a portion of each of at least some areas.

At operation S240, after the bank QBNK is patterned, the color conversion layer CCL including quantum dots QD may be disposed on the color filter layer CFL through an inkjet process. Hence, the color conversion layer CCL may be patterned in the first sub-pixel area SPXA1. For example, ink including materials for forming the color conversion layer CCL may be supplied to an area enclosed by the bank QBNK. The present disclosure is not limited to the aforementioned example. In some embodiments, the color conversion layer CCL may be patterned, based on a photolithography process. Therefore, the first capping layer QCP1 for passivating (e.g., capping) the color conversion layer CCL may be formed (e.g., deposited) on the overall area of the upper substrate USUB.

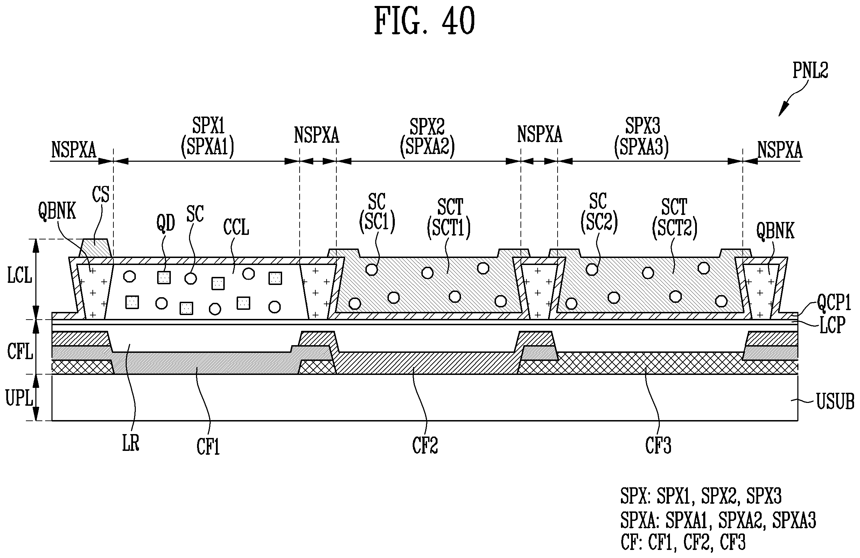

Referring to FIGS. 40-42, at operation S240, a process of forming the first scattering layer SCT1 and the second scattering layer SCT2 may be performed.

For example, referring to FIG. 40, the first scattering layer SCT1 and the second scattering layer SCT2 may be patterned in each of the second sub-pixel area SPXA2 and the third sub-pixel area SPXA3. The spacer CS may be formed (e.g., simultaneously formed) in the non-sub-pixel area NSPXA.

In some embodiments, the first scattering layer SCT1, the second scattering layer SCT2, and the spacer CS may be patterned, based on a photolithography process. Thereafter, although not illustrated in FIG. 40, the second capping layer QCP2 may be formed (e.g., deposited) to passivate the first scattering layer SCT1, the second scattering layer SCT2, and the spacer CS.

In some embodiments, it may be suitable for the spacer CS to be spaced apart from the upper substrate USUB, compared to other components of the light controlling layer LCL such as the first scattering layer SCT1 and the second scattering layer SCT2. Hence, the spacer CS may be disposed on the bank QBNK forming a relatively high base, thus forming a protruding structure. In some embodiments, if the height of the spacer CS is excessively large, a cell gap between the first panel PNL1 and the second panel PNL2 may be excessively formed during a subsequent process. Hence, in some embodiments, an additional process of removing at least a portion of the spacer CS may be performed.

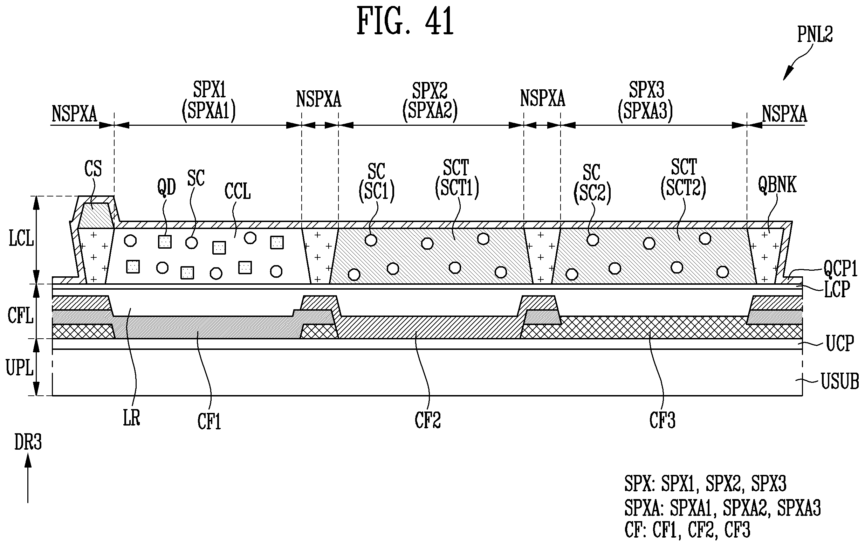

In another example, referring to FIG. 41, after the color conversion layer CCL is fabricated based on a photolithography process, the first scattering layer SCT1 and the second scattering layer SCT2 may be patterned before the first capping layer QCP1 is formed. For example, the first scattering layer SCT1 and the second scattering layer SCT2 may be patterned based on a photolithography process. The spacer CS may be patterned through the same process as the first scattering layer SCT1 and the second scattering layer SCT2. After the first scattering layer SCT1 and the second scattering layer SCT2 are formed, the first capping layer QCP1 may be fabricated.

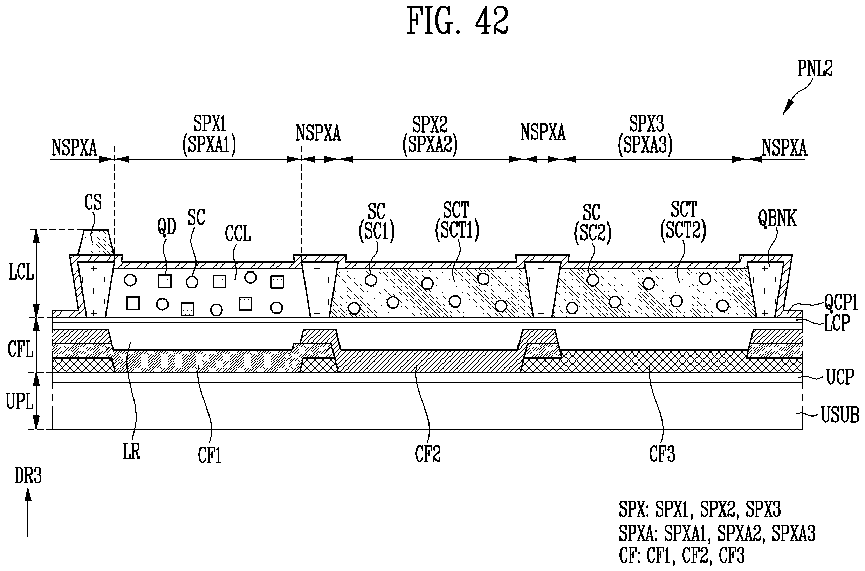

In another example, referring to FIG. 42, before the first capping layer QCP1 is formed, the first scattering layer SCT1 and the second scattering layer SCT2 may be fabricated through an inkjet process. Thereafter, the first capping layer QCP1 may be formed to cover the color conversion layer CCL, the first scattering layer SCT1, and the second scattering layer SCT2. The spacer CS may be patterned through a separate photolithography process. Thereafter, although not illustrated in FIG. 42, the second capping layer QCP2 may be formed (e.g., deposited) to passivate the first scattering layer SCT1, the second scattering layer SCT2, and the spacer CS.

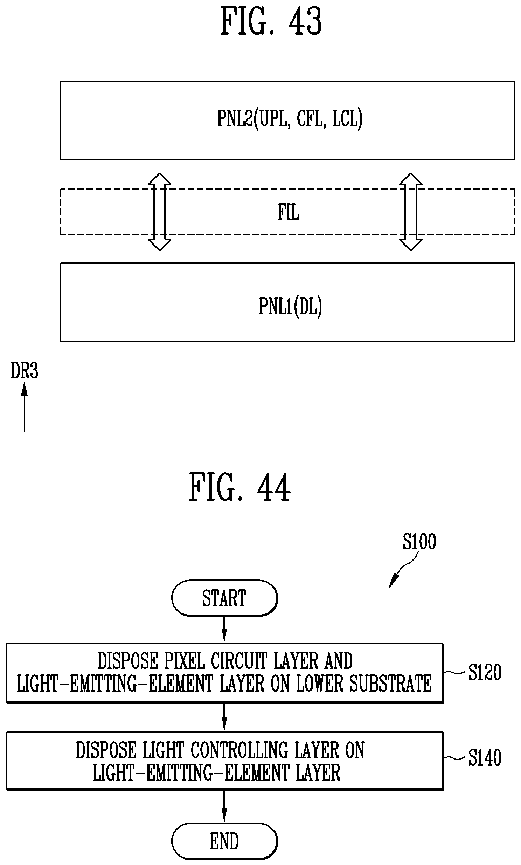

Referring to FIGS. 36 and 43, at operation S300 of coupling the first panel and the second panel to each other, the filler layer FIL may be interposed between the first panel PNL1 and the second panel PNL2, and the first panel PNL1 and the second panel PNL2 may be adjacent to each other.

At operation S300, the first panel PNL1 including the display layer DL may be coupled to the second panel PNL2 including the upper layer UPL, the color filter layer CFL, and the light controlling layer LCL. In some embodiments, the spacer CS is formed so that the first panel PNL1 and the second panel PNL2 can be appropriately coupled to each other.

FIGS. 36 and 44-48 illustrate a method of fabricating the display device DD in such a way that the first panel PNL1 and the second panel PNL2 are separately provided and then coupled to each other, showing an embodiment in which the light controlling layer LCL is included in the first panel PNL1.

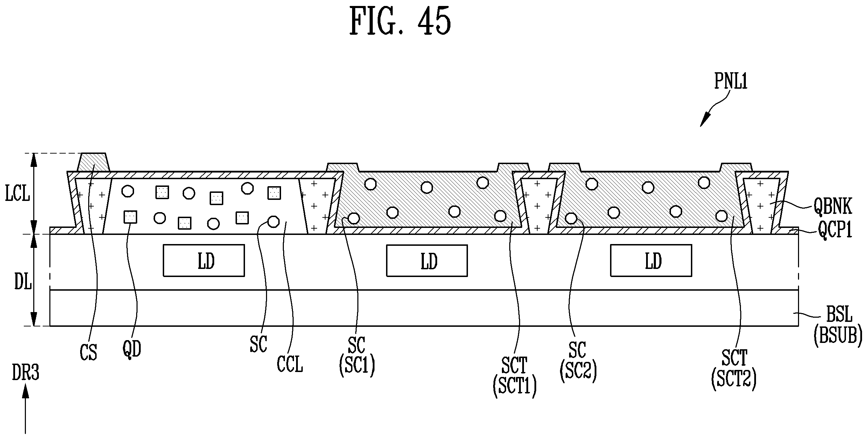

FIG. 44 is a flowchart illustrating sub-operations of the operation of fabricating the first panel in some embodiments. FIGS. 45-48 are schematic sectional views illustrating, by process operations, the method of fabricating the display device in some embodiments.

Comparing with the fabrication method described above with reference to FIGS. 36-43, the method of fabricating the display device DD in some embodiments will be described with a focus on the differences.

In some embodiments, the method of fabricating the display device DD may include operation S100 of fabricating the first panel, operation S200 of fabricating the second panel, and operation S300 of coupling the first panel and the second panel. Referring to FIG. 44, operation S100 of fabricating the first panel may include operation S120 of disposing the pixel circuit layer and the light-emitting-element layer on the lower substrate, and operation S140 of disposing the light controlling layer on the light-emitting-element layer.

In some embodiments, after operation S120 of disposing the pixel circuit layer and the light-emitting-element layer on the lower substrate is performed, layers forming the light controlling layer LCL may be disposed on the fabricated display layer DL (e.g., the light-emitting-element layer LEL).

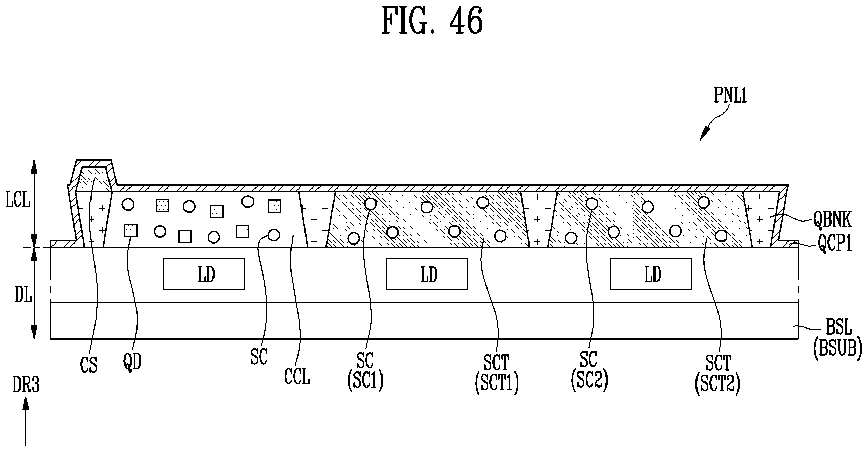

For example, referring to FIGS. 45 and 46, at operation S140, the color conversion layer CCL, the first scattering layer SCT1, and the second scattering layer SCT2 may be disposed on the display layer DL to fabricate the first panel PNL1.

In some embodiments (refer to FIG. 45), at operation S140, the color conversion layer CCL may be fabricated on the display layer DL through an inkjet process. After the first capping layer QCP1 passivating the color conversion layer CCL is formed, the first scattering layer SCT1, the second scattering layer SCT2, and the spacer CS may be fabricated through a photolithography process.

In some embodiments (refer to FIG. 46), at operation S140, the color conversion layer CCL may be fabricated through an inkjet process. The first scattering layer SCT1, the second scattering layer SCT2, and the spacer CS may be fabricated through a photolithography process. Thereafter, the first capping layer QCP1 may be formed.

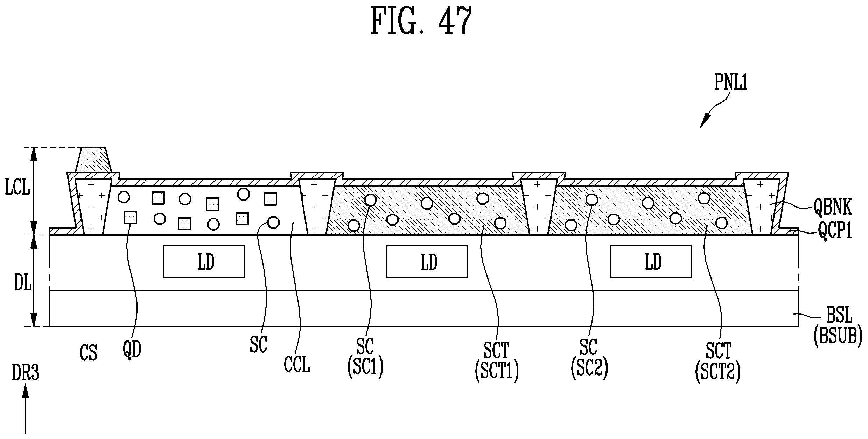

In some embodiments (refer to FIG. 47), at operation S140, the color conversion layer CCL, the first scattering layer SCT1, and the second scattering layer SCT2 may be fabricated through an inkjet process. After the first capping layer QCP1 is formed, the spacer CS may be fabricated through a photolithography process.

In some embodiments, operation S200 of fabricating the second panel is performed so that the second panel PNL2 in which the color filter layer CFL is disposed on the upper substrate USUB can be provided.

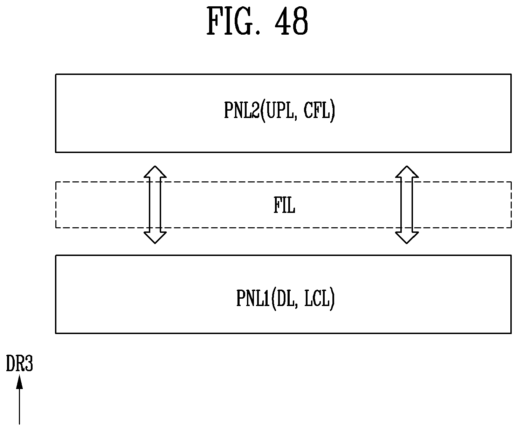

Referring to FIGS. 36 and 48, at operation S300 of coupling the first panel and the second panel to each other, the filler layer FIL may be interposed between the first panel PNL1 and the second panel PNL2, and the first panel PNL1 and the second panel PNL2 may be adjacent to each other.

At operation S300, the first panel PNL1 including the display layer DL and the light controlling layer LCL may be coupled to the second panel PNL2 including the upper layer UPL and the color filter layer CFL.

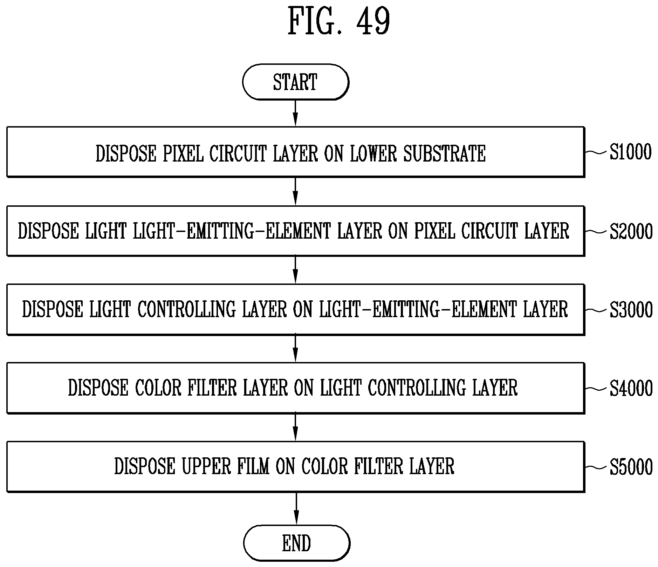

FIG. 49 illustrates a method of fabricating the display device DD in such a way that layers of the display device DD are successively disposed on the lower substrate BSUB without fabricating the second panel PNL2.

FIG. 49 is a flowchart illustrating a method of fabricating the display device in some embodiments.

Comparing with the fabrication method described above with reference to FIGS. 36-48, the method of fabricating the display device DD in some embodiments will be described with a focus on the differences.

In some embodiments, the method of fabricating the display device DD may include operation S1000 of disposing the pixel circuit layer on the lower substrate, operation S2000 of disposing the light-emitting-element layer on the pixel circuit layer, operation S3000 of disposing the light controlling layer on the light-emitting-element layer, operation S4000 of disposing the color filter layer on the light controlling layer, and operation S5000 of disposing the upper film layer on the color filter layer.

In other words, in some embodiments, the display layer DL, the light controlling layer LCL, the color filter layer CFL, and the upper layer UPL may be successively formed on the lower substrate BSUB provided as a base, without forming the upper substrate USUB. In some embodiments, the process of fabricating each of the layers ay be specified with reference to the aforementioned contents. For example, various processes such as an inkjet process and/or a photolithography process may be utilized (e.g., used) to form the light controlling layer LCL.

While various embodiments have been described above, those skilled in the art will appreciate that various modifications, additions and substitutions are possible, without departing from the scope and spirit of the present disclosure.

Therefore, the embodiments disclosed in this specification are only for illustrative purposes rather than limiting the technical spirit of the present disclosure. The scope of the present disclosure shall be defined by the accompanying claims.

## Claims

1. A display device, comprising:
sub-pixels formed on a base layer, and comprising: a first sub-pixel forming a first sub-pixel area and configured to provide light of a first color; a second sub-pixel forming a second sub-pixel area and configured to provide light of a second color; and a third sub-pixel forming a third sub-pixel area and configured to provide light of a third color, the sub-pixels comprising:
a display layer comprising a light emitting element on the base layer;
a light controlling layer on the display layer, and comprising:
a color conversion layer in the first sub-pixel area and comprising a quantum dot;
a first scattering layer in the second sub-pixel area and comprising a first scatterer; and
a second scattering layer in the third sub-pixel area and comprising a second scatterer; and
a color filter layer on the light controlling layer, and comprising a first color filter in the first sub-pixel area, a second color filter in the second sub-pixel area, and a third color filter in the third sub-pixel area,
wherein emitted light from the light emitting element comprises light of the second color and light of the third color, and at least a portion of the emitted light is emitted through the light controlling layer and the color filter layer, and
wherein colors of light passing through the first scattering layer and the second scattering layer are substantially unchanged by the first scattering layer and the second scattering layer.

2. The display device according to claim 1, further comprising a capping layer, at least a portion of the capping layer being configured to passivate the color conversion layer,
wherein a first portion of the capping layer is on the color conversion layer in the first sub-pixel area, and a second portion of the capping layer is under the first scattering layer and the second scattering layer respectively in the second sub-pixel area and the third sub-pixel area.

3. The display device according to claim 2, further comprising an upper layer on the color filter layer, and comprising an upper substrate,
wherein the color filter layer and the light controlling layer are sequentially layered below the upper substrate, and
wherein a filler layer is between the display layer and the color conversion layer, the first scattering layer, and the second scattering layer.

4. The display device according to claim 2, further comprising an upper layer on the color filter layer, and comprising an upper substrate,
wherein the light controlling layer is on the display layer, and
wherein a filler layer is between the color filter layer and the color conversion layer, the first scattering layer, and the second scattering layer.

5. The display device according to claim 2, further comprising an upper layer on the color filter layer, and comprising an upper film,
wherein the light controlling layer and the color filter layer are successively layered on the display layer.

6. The display device according to claim 1, wherein the color conversion layer has a first thickness,
wherein the first scattering layer has a second thickness,
wherein the second scattering layer has a third thickness,
wherein the first thickness is greater than each of the second thickness or the third thickness, and
wherein the second thickness is substantially equal to the third thickness.

7. The display device according to claim 1, wherein the first scatterer and the second scatterer are comprised in a range from about 1.5 wt% to about 8.5 wt% with respect to the first scattering layer and the second scattering layer, respectively.

8. The display device according to claim 1, wherein a size of the first scatterer is greater than a size of the second scatterer.

9. The display device according to claim 1, wherein the first scatterer is included at a first weight ratio with respect to the first scattering layer,
wherein the second scatterer is included at a second weight ratio with respect to the second scattering layer, and
wherein the first weight ratio is greater than the second weight ratio.

10. The display device according to claim 1, wherein the first scattering layer comprises one or more scatterers having a same composition ratio as the first scatterer and a different size than the first scatterer, and
wherein the second scatter layer comprises one or more scatterers having a same composition ratio as the second scatterer and a different size than the second scatterer.

11. The display device according to claim 1, wherein the color filter layer further comprises an optical layer having a refractive index less than a refractive index of the color conversion layer, the optical layer being disposed between the light controlling layer and the first color filter, the second color filter, and the third color filter, and
wherein, among the first sub-pixel area, the second sub-pixel area, and the third sub-pixel area, only the first sub-pixel area comprises the optical layer.

12. The display device according to claim 1, further comprising a filler scattering layer in the second sub-pixel area and the third sub-pixel area, the filler scattering layer overlapping with the first scattering layer and the second scattering layer in a thickness direction, and comprising a filler material and a scattering material.

13. The display device according to claim 1, further comprising a bank, wherein at least a portion of the bank encloses the first sub-pixel area, and extends in a thickness direction.

14. The display device according to claim 13, wherein the bank is not between the second sub-pixel area and the third sub-pixel area, and
wherein the display device further comprising a black matrix layer, at least a portion of the black matrix layer being between the second sub-pixel area and the third sub-pixel area, the black matrix layer penetrating between the first scattering layer and the second scattering layer.

15. The display device according to claim 13, wherein the bank is formed around all sides of the first sub-pixel area in a plan view, and is not formed around at least a portion of each of the second sub-pixel area and the third sub-pixel area.

16. The display device according to claim 15,
wherein at least one side of the second sub-pixel area includes an open edge on which the bank is not formed, and
wherein the open edge is formed to be oriented in a direction away from the third sub-pixel area.

17. The display device according to claim 13, wherein the bank is formed around all sides of both the first sub-pixel area and the second sub-pixel area in a plan view, and is not formed around at least a portion of the third sub-pixel area.

18. The display device according to claim 17, further comprising a capping layer, at least a portion of the capping layer being configured to passivate the color conversion layer and the first scattering layer,
wherein a portion of the capping layer is in the third sub-pixel area between the second scattering layer and the third color filter.

19. The display device according to claim 18, wherein a thickness of the first scattering layer is greater than a thickness of the second scattering layer.

20. The display device according to claim 13, wherein the bank further comprises an isolated bank component, and
wherein the isolated bank component is between the second sub-pixel area and the third sub-pixel area.

21. The display device according to claim 13, further comprising a spacer on the bank and above the color conversion layer, the first scattering layer, and the second scattering layer.

22. The display device according to claim 21, wherein the spacer is between the first sub-pixel area and the second sub-pixel area, between the second sub-pixel area and the third sub-pixel area, and between the first sub-pixel area and the third sub-pixel area.

23. The display device according to claim 21, wherein the first sub-pixel, the second sub-pixel, and the third sub-pixel are adjacent to each other in a first direction, and form a first pixel,
wherein the first pixel is adjacent to a second pixel in a second direction different from the first direction, and
wherein the spacer is between the first sub-pixel area of the first pixel and the first sub-pixel area of the second pixel, between the second sub-pixel area of the first pixel and the second sub-pixel area of the second pixel, and between the third sub-pixel area of the first pixel and the third sub-pixel area of the second pixel.

24. The display device according to claim 21, wherein the first sub-pixel area and the third sub-pixel area are adjacent to each other in a first direction, and the second sub-pixel area is adjacent to the first sub-pixel area and the third sub-pixel area in a second direction different from the first direction, and
wherein the spacer overlaps with the second sub-pixel area in the first direction.

25. The display device according to claim 21, further comprising a capping layer, at least a portion of the capping layer being configured to passivate the color conversion layer, the bank, the first scattering layer, the second scattering layer, and the spacer.

26. The display device according to claim 21, further comprising a capping layer,
wherein at least a portion of the capping layer is configured to passivate the color conversion layer, the bank, the first scattering layer, and the second scattering layer, and
wherein the spacer is disposed on the capping layer.

27. The display device according to claim 26, wherein the bank comprises:
a first bank part spaced apart from a second bank part by a first distance, the second sub-pixel area being between the first bank part and the second bank part; and
a third bank part spaced apart from the second bank part by a second distance, the third sub-pixel area being between the third bank part and the second bank part; and
wherein a thickness of the first scattering layer is greater than a thickness of the second scattering layer.

28. The display device according to claim 1, wherein the light emitting element comprises one or more of an organic light emitting diode comprising an organic material, or an inorganic light emitting diode comprising an inorganic material.

29. A method of fabricating a display device, comprising:
fabricating a first panel;
fabricating a second panel; and
coupling the first panel and the second panel to each other,
wherein fabricating the first panel comprises providing a light emitting element on a lower substrate,
wherein fabricating the second panel comprises providing a color filter layer on an upper substrate, and providing a light controlling layer on the color filter layer,
wherein the providing the light controlling layer comprises:
patterning a bank on the color filter layer;
placing a color conversion layer comprising a quantum dot in a first sub-pixel area;
placing a first scattering layer comprising a first scatterer in a second sub-pixel area; and
placing a second scattering layer comprising a second scatterer in a third sub-pixel area, and
wherein the first scattering layer and the second scattering layer are configured to allow incident light to pass through the first scattering layer and the second scattering layer without changing a color of the incident light.

30. The method according to claim 29, wherein the providing the light controlling layer further comprises forming a capping layer on the color conversion layer, the capping layer being configured to passivate the color conversion layer,
wherein the providing the color conversion layer comprises patterning the color conversion layer through an inkjet process, and
wherein the providing the first scattering layer and providing the second scattering layer are performed after forming the capping layer, and are performed based on a photolithography process.

31. The method according to claim 29, wherein the color conversion layer, the first scattering layer, and the second scattering layer are patterned based on a photolithography process, and
wherein the providing the light controlling layer further comprises forming a capping layer on the color conversion layer, the capping layer being configured to passivate the color conversion layer.

32. The method according to claim 29, wherein the color conversion layer, the first scattering layer, and the second scattering layer are formed based on an inkjet process.

33. The method according to claim 29, wherein coupling the first panel and the second panel further comprises providing a filler layer between the first panel and the second panel.

34. A method of fabricating a display device, comprising:
fabricating a first panel;
fabricating a second panel; and
coupling the first panel and the second panel to each other,
wherein the fabricating the first panel comprises providing a display layer comprising a light emitting element on a lower substrate, and providing a light controlling layer on the display layer,
wherein the fabricating the second panel comprises providing a color filter layer on an upper substrate,
wherein the providing the light controlling layer comprises:
patterning a bank on the display layer;
providing a color conversion layer comprising a quantum dot in a first sub-pixel area;
providing a first scattering layer comprising a first scatterer in a second sub-pixel area; and
providing a second scattering layer comprising a second scatterer in a third sub-pixel area, and
wherein the first scattering layer and the second scattering layer are configured to allow incident light to pass through the first scattering layer and the second scattering layer without changing a color of the incident light.

35. The method according to claim 34, wherein providing the light controlling layer further comprises forming a capping layer on the color conversion layer, the capping layer being configured to passivate the color conversion layer,
wherein providing the color conversion layer comprises patterning the color conversion layer through an inkjet process, and
wherein providing the first scattering layer and providing the second scattering layer are performed after forming the capping layer, and are performed based on a photolithography process.

36. The method according to claim 34, wherein the color conversion layer, the first scattering layer, and the second scattering layer are patterned based on a photolithography process, and
wherein providing the light controlling layer further comprises forming a capping layer on the color conversion layer, the capping layer being configured to passivate the color conversion layer, the first scattering layer, and the second scattering layer.

37. The method according to claim 34, wherein the color conversion layer, the first scattering layer, and the second scattering layer are formed based on an inkjet process.
